# EUROPEAN PATENT APPLICATION

(11) **EP 4 016 217 A1**
(43) Date of publication of application: **22.06.2022**
(21) Application number: 21208457.8
(22) Date of filing: 16.11.2021
(51) Int. Cl.: G05B 19/418

(54) **PLANNING SYSTEM AND METHOD FOR PROCESSING WORKPIECES**

(30) Priority: 17.12.2020 US 202063127124 P
(71) Applicant: Aurora Flight Sciences Corporation, Manassas, VA 20110 (US)
(72) Inventor: Jensen, Devin Richard, Manassas, VA, 20110 (US); Snider II, James McDaniel, Manassas, VA, 20110 (US); Bosworth, William Robert, Manassas, VA, 20110 (US)
(74) Representative: Hoffmann Eitle

(57) **Abstract**

A planning system (100) for simulating the processing of workpieces (452) includes, a simulation manager (220), configured to receive a software model (250) of a manufacturing cell (400), including state machines (256) for performing timed actions on the workpieces (452). The simulation manager (220) is configured to perform the steps of: creating an instance of the software model (250) and a simulation controller (206), determining the next timed action to be performed by the state machines (256), incrementing the simulation to the next timed action, updating the software model (250) and the simulation controller (206) each time a state machines (256) performs a timed action, recording the state transitions associated with the timed action, and repeating the steps of determining the next timed action, incrementing the simulation, and updating the software model (250) and the simulation controller (206), until all of the workpieces (452) have been processed. The simulation manager (220) configured to output a simulated completion time for processing the workpiece order.

## Description

### FIELD

The present disclosure relates generally to manufacturing systems and, more particularly, to a planning system for processing workpieces in a manufacturing cell.

### BACKGROUND

Factories or production plants inherently include a limited amount of factory resources for processing workpieces or parts. Factory resources may include technicians (e.g., personnel) and automated equipment. The processing of workpieces may include creating workpieces from raw material, and/or performing processing operations on precursor workpieces, such as machining, drilling, and trimming operations. Processing may additionally include the cleaning and/or inspection of workpieces during or after the manufacturing cycle.

Conventional factories are typically configured for high-rate linear production of a single program, wherein the factory resources are configured to perform a predetermined set of operations in the same sequence on the same workpiece configuration. Such an arrangement can lead to underutilization of certain factory resources when workpieces must wait for certain operations to be performed (e.g., machining) prior to undergoing other operations (e.g., inspection), and which may result in low production throughput. For low or medium-rate production for a single program, the costs associated with installing, operating, and maintaining factory resources may be prohibitively high. For processing different workpiece configurations requiring the same types of operations, processing of the workpieces in a linear sequence may result in underutilization of factory resources

As can be seen, there exists a need in the art for a system and method for scheduling the processing of workpieces in a manner that avoids underutilization of factory resources, and which aids in making design decisions such as on resource requirements and factory layout. Ideally, the system is capable of scheduling factory resources for processing of workpieces in parallel for multiple low or medium-rate production programs, and for processing different workpiece configurations in a non-linear sequence.

### SUMMARY

The above-noted needs associated with manufacturing systems are specifically addressed and alleviated by the present disclosure which provides a planning system for simulating the processing of workpieces by a manufacturing cell. The planning system includes a production utilization planner (PUP) core having a simulation and analysis module having a processor and a memory storing instructions that, when executed by the processor, cause the simulation and analysis module to perform as a simulation manager. The simulation manager is configured to receive simulation manager inputs, including a software model of the manufacturing cell. The software model has model components including a plurality of state machines and a plurality of work articles. Each of the state machines is configured to perform one or more timed actions on the work articles, and each state machine has a defined state respectively during and between the timed actions, and a defined state transition from state to state. The work articles comprise workpieces, each having a workpiece configuration. The simulation manager is also configured to receive a production configuration comprising a list of workpieces to be processed by the manufacturing cell, each having one of the workpiece configurations defined in the software model.

The simulation manager is configured to perform a simulation analysis of the processing, via the state machines, of the workpieces arranged in a workpiece order, by performing the following steps: creating, at initiation of the simulation, an instance of the software model and an instance of a simulation controller. The simulation controller has a pre-programmed set of rules for determining the order in which the timed actions are performed on the workpieces in the workpiece order. The simulation analysis further includes determining, via the simulation controller, a next timed action to be performed by the state machines, incrementing the simulation to the next timed action, and updating the software model and the simulation controller each time one of the state machines performs a timed action, and recording the state transitions associated with the timed action. In addition, the simulation analysis includes repeating the steps of determining the next timed action, incrementing the simulation, and updating the software model and the simulation controller, until all of the workpieces in the workpiece order have been processed. The simulation manager is configured to output a simulated completion time for processing the workpiece order, and a state transition log of the state transitions recorded for each state machine during processing of the workpiece order.

Also disclosed is a planning system configured similar to the above-described planning system, and in which the state machines comprise workers, workpiece stations, and automated ground vehicles (AGVs), and the work articles comprise workpieces and pallets for supporting the workpieces. The workers comprise one or more technicians and/or one or more robotic devices. The timed actions performed by the workers include operating on the workpieces when the pallets are loaded onto the workpiece stations. The timed actions performed by the AGVs include transporting the pallets between the workpiece stations.

In addition to the above-described planning systems, disclosed is a method of simulating the processing of workpieces by a manufacturing cell. The method includes receiving, in a simulation manager of a production utilization planner (PUP) core, simulation manager inputs including a software model of the manufacturing cell. The software model has model components including a plurality of state machines and a plurality of work articles. The state machines are configured to perform one or more timed actions on the work articles, and each state machine has a defined state respectively during and between the timed actions, and a defined state transition from state to state. The work articles comprise workpieces each having a workpiece configuration. The simulation manager is also configured to receive a production configuration comprising a list of workpieces to be processed by the manufacturing cell, each having one of the workpiece configurations defined in the software model.

The method includes simulating, via the simulation manager, the processing of the workpieces arranged in a workpiece order, by creating, at initiation of the simulation, an instance of the software model and an instance of a simulation controller. The simulation controller has a pre-programmed set of rules for determining the order in which the timed actions are performed on the workpieces in the workpiece order. The method also includes determining, via the simulation controller, a next timed action to be performed by the state machines, incrementing the simulation to the next timed action, and updating the software model and the simulation controller each time one of the state machines performs a timed action, and recording the state transitions associated with the timed action. The method additionally includes repeating the steps of determining the next timed action, incrementing the simulation, and updating the software model and the simulation controller, until all of the workpieces in the workpiece order have been processed. Furthermore, the method includes outputting a simulated completion time for processing the workpiece order, and a state transition log of the state transitions recorded for each state machine during processing of the workpiece order.

The features, functions and advantages that have been discussed can be achieved independently in various examples of the present disclosure or may be combined in yet other examples, further details of which can be seen with reference to the following description and drawings below.

### BRIEF DESCRIPTION OF THE DRAWINGS

These and other features of the present disclosure will become more apparent upon reference to the drawings wherein like numbers refer to like parts throughout and wherein:
Figure 1 is a block diagram of a planning system for simulating the processing of workpieces by a manufacturing cell;
Figure 2 is a perspective view of an example of a manufacturing cell for processing workpieces;
Figure 3 is a plan view of a manufacturing cell illustrating robotic devices mounted within a machining subcell and an inspection subcell, and further illustrating autonomous ground vehicles (AGVs) for transporting workpieces to and from the workpiece stations;
Figure 4 is a perspective view of an example of an AGV transporting a pallet and approaching an entrance to the machining subcell;
Figure 5 is a perspective view of an example of the machining subcell with the roof removed to illustrate a pair of robotic devices mounted within the machining subcell, and illustrating a pair of workpiece stations located proximate each robotic device;
Figure 6 is a perspective view of an example of a robotic device in the machining subcell operating on a workpiece supported on a pallet mounted on a station frame at one of the workpiece stations;
Figure 7 is a perspective view of a station frame mounted to the floor of the manufacturing cell at one of the workpiece stations;
Figure 8 is a perspective view of a pallet mounted to the station frame at the workpiece station;
Figure 9 is a perspective view of an example of an AGV having a pair of forks which are shown inserted into a pair of fork tubes of a pallet in preparation for lifting the pallet off the station frame at the workpiece station;
Figure 10 is a block diagram of a plant utilization planner (PUP) core of the planning system of Figure 1;
Figure 11 is a block diagram of a simulation and analysis module of the PUP core;
Figure 12 is a block diagram of a software model of the manufacturing cell containing state machines and work articles;
Figure 13 is a block diagram of a simulation manager of the simulation and analysis module;
Figure 14 is a graph of simulation time vs. work completed (timed actions) for the simulation of workpiece orders by the manufacturing cell, and illustrating a plot of the best-case completion time of a workpiece order of a statistical model, and a plot of a fully run simulation of a workpiece order, a plot of a terminated simulation of a workpiece order, and also illustrating a plot of a threshold beyond which simulations are terminated;
Figure 15 is a block diagram of a batch analysis tool of the simulation and analysis module;
Figure 16 is a block diagram of an uncertainty analysis tool of the simulation and analysis module;
Figure 17 is a block diagram of a controller analysis tool of the simulation and analysis module;
Figure 18 is a block diagram of a discrepancy hunter of a health monitor module of the PUP core;
Figure 19 is a block diagram of an error predictor of the health monitor module;
Figure 20 shows an example of a factory display of a user interface of the planning system, for indicating the status and performance of the manufacturing cell;
Figure 21 is a flowchart of a method of simulating the processing of workpieces by a manufacturing cell.

### DETAILED DESCRIPTION

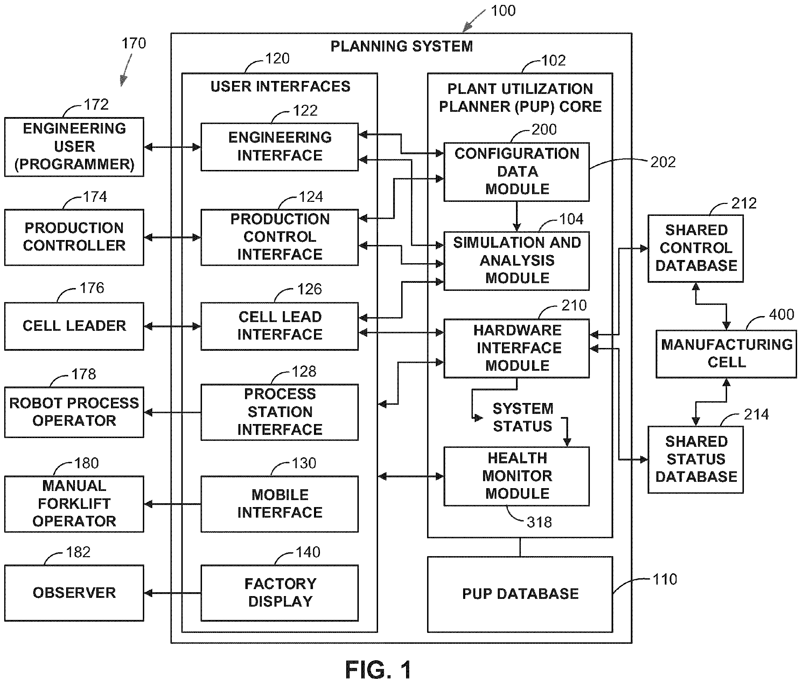

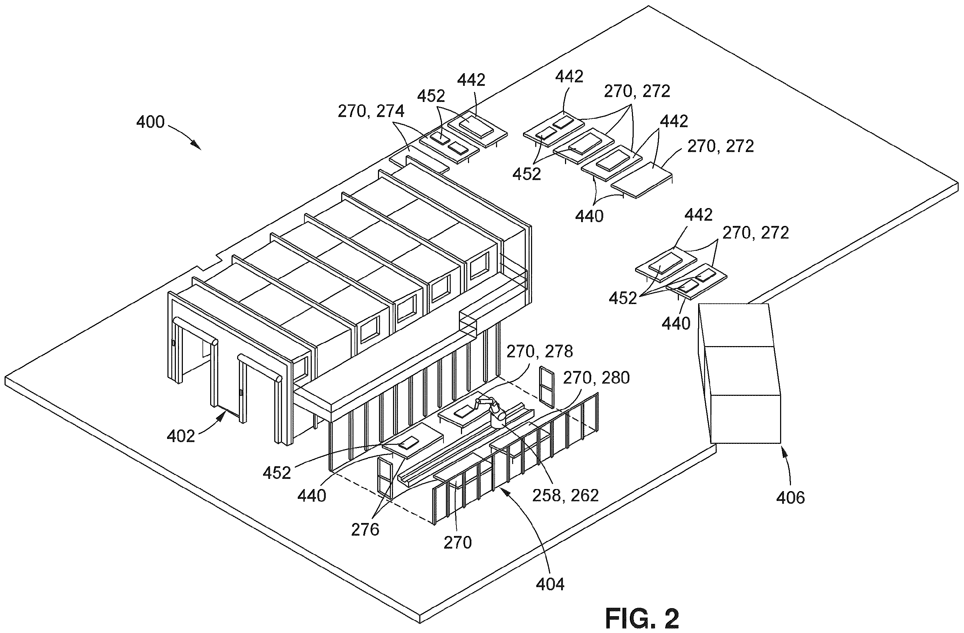

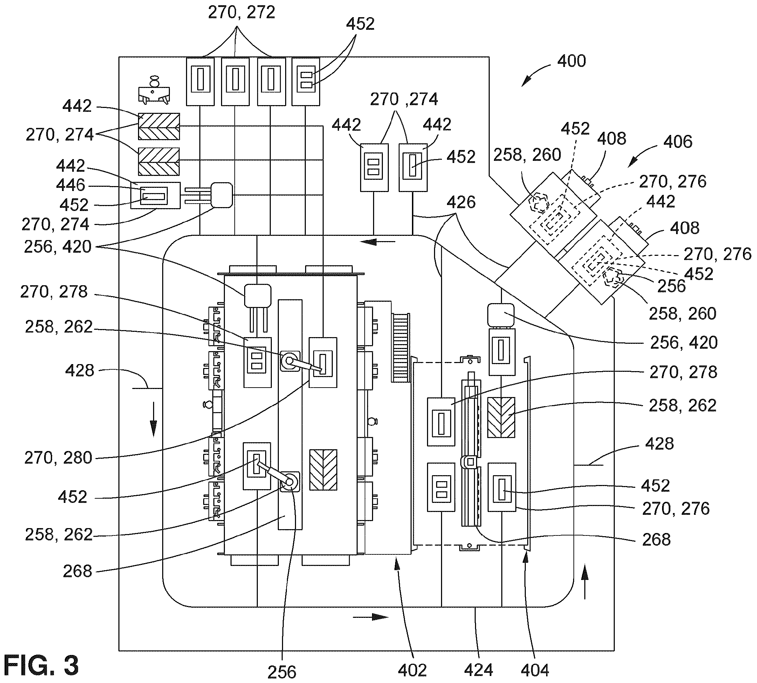

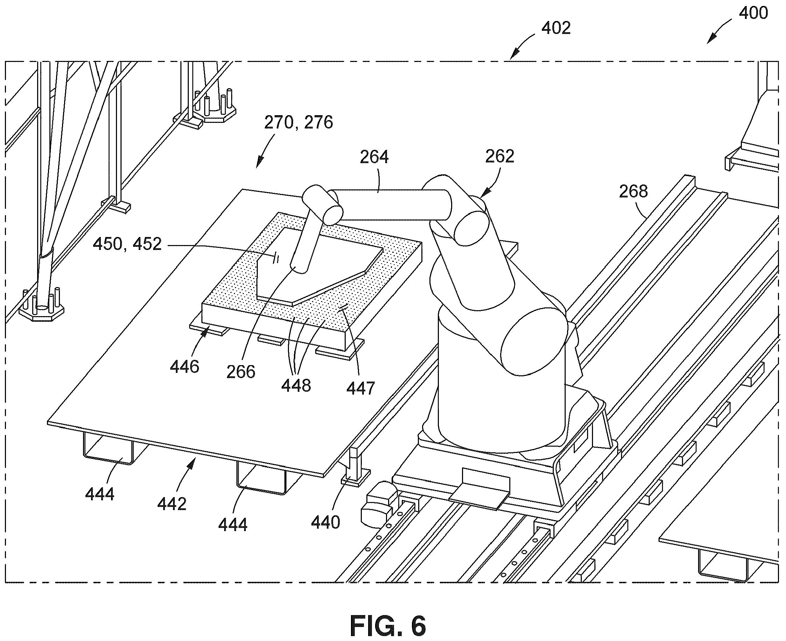

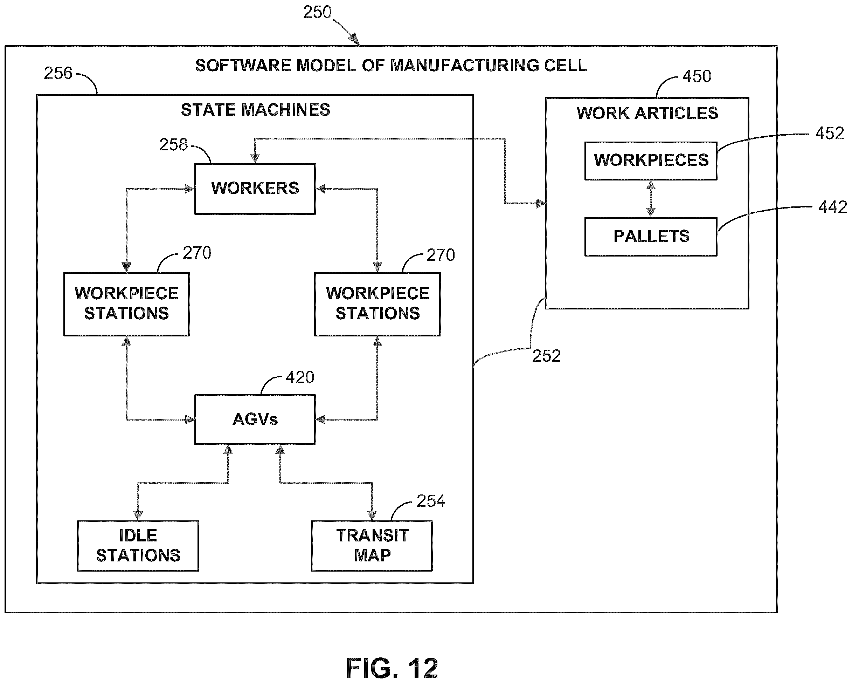

Referring now to the drawings which illustrate preferred and various examples of the disclosure, shown in Figure 1 is block diagram of a planning system 100 for simulating the processing of a plurality of workpieces 452 (Figure 6) by a manufacturing cell 400 (e.g., Figures 2-3) of a factory (not shown). The presently-disclosed planning system 100 simulates workpiece processing in any one of a variety different manufacturing cell configurations and/or factory configurations, and is not limited to simulating workpiece processing in the manufacturing cell illustrated in Figures 2-9. The planning system 100 provides a means for determining the total amount of time (i.e., the completion time) required for completing the processing of all of the workpieces 452 in a workpiece order. The manufacturing cell 400 includes workers 258 (Figures 3 and 12) for processing a plurality of workpieces 452. The workers 258 include human workers (e.g., technicians 260 - Figure 3) and/or machine workers (e.g., robotic devices 262 - Figure 3) as described below. The planning system 100 includes a plant utilization planner (PUP) core 102, and may include one or more user interfaces 120 to allow users 170 (i.e., humans) to interact with the PUP core 102 and monitor the operation of the manufacturing cell 400. The planning system 100 provides the ability to optimize the order (i.e., the workpiece order) in which a plurality of workpieces 452 are processed by the manufacturing cell 400. By optimizing the workpiece order, underutilization of workers 258 (i.e., factory resources) is avoided, and which result in an increase in production throughput of the manufacturing cell 400.

The ability to simulate workpiece processing facilitates the ability to evaluate the impact of changes to the configuration of a manufacturing cell 400. For example, the ability to simulate workpiece processing is an aid designers in making decisions on procurement of production equipment (e.g., pallets 442, station frames 440, robotic devices 262, automated ground vehicles 420, etc. - Figures 2-3), decisions on the floor layout of the workers 258 (e.g., technicians 260, robotic devices 262, etc.), and decisions on factory expansion. In addition, the planning system 100 provides a means for predicting the impact of adding new workpiece configurations for processing by an existing manufacturing cell 400. In this regard, the planning system 100 enables scheduling for multiple low to medium-rate production programs for processing workpieces 452 in parallel using shared workers 258. Further in this regard, the planning system 100 enables scheduling for processing different workpiece configurations in a non-linear sequence, including for short-duration production runs.

Referring to Figures 2-9, shown is an example of a manufacturing cell 400, which is included in the present disclosure to provide context for describing the operation of the planning system 100. The manufacturing cell 400 may be part of a factory, and includes a plurality of workpiece stations 270, each of which is configured to support one or more workpieces 452. The manufacturing cell 400 also includes one or more autonomous ground vehicles (AGVs 420 - Figure 3) which are configured to autonomously (i.e., without human intervention) transport workpieces 452 to and from the workpiece stations 270. The workpieces 452 are supported on pallets 442, and are transported by the AGVs 420.

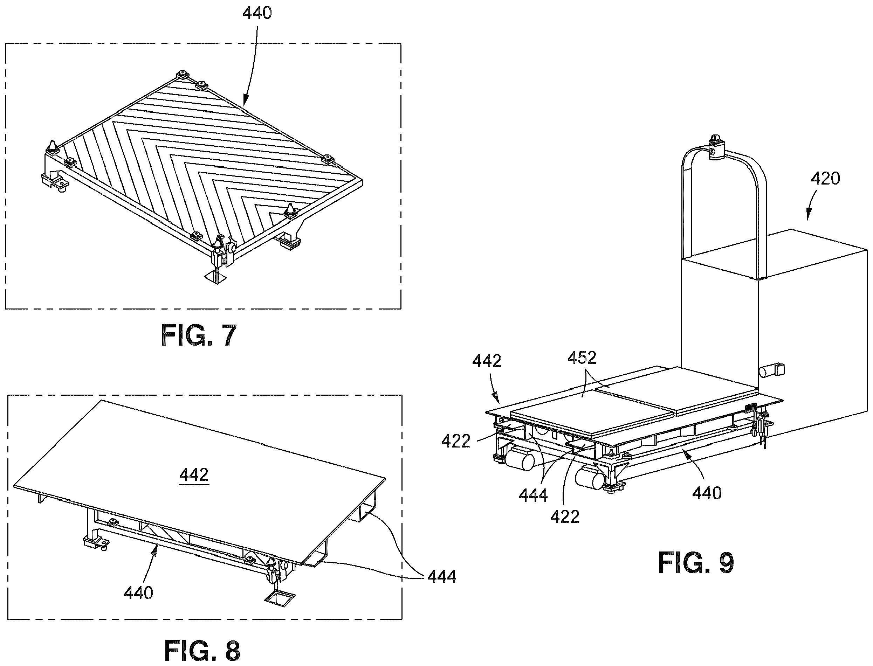

The workpiece stations 270 may include feed stations 272 and buffer stations 274. In addition, the workpiece stations 270 include processing stations 276 as shown in Figures 2-3. Each workpiece station 270 is configured to support one or more workpieces 452. In some examples, the workpiece stations 270 may each include a station frame 440 (Figure 7) configured to support a pallet 442 (Figure 8) which, in turn, support one or more workpieces 452 (Figure 6), as described in greater detail below. Each of the feed stations 272 is configured to support at least one workpiece 452 for entry into the manufacturing cell 400. The workpiece 452 (and pallet 442) may be moved from storage via a manual forklift operator 180 (Figure 1), and loaded onto the feed station 272. The workpiece 452 is picked up by an AGV 420 and transported to a processing station 276 where the workpiece 452 is operated on by a worker 258 (e.g., a technician 260 or a robotic device 262) in accordance with predetermined processing operations defined for the workpiece 452. After the manufacturing cell 400 has completed all processing operations defined for the workpiece 452, an AGV 420 may return the workpiece 452 to one of the feed stations 272, after which the workpiece 452 (and pallet 442) may be removed (e.g., manually, via forklift) from the feed station 272 and placed back in storage, or transported to another location in the factory for further processing of the workpiece 452. The manufacturing cell 400 may include one or more buffer stations 274 for temporarily supporting any one of the workpieces 452 or pallets 442 in between the processing of a workpiece 452.

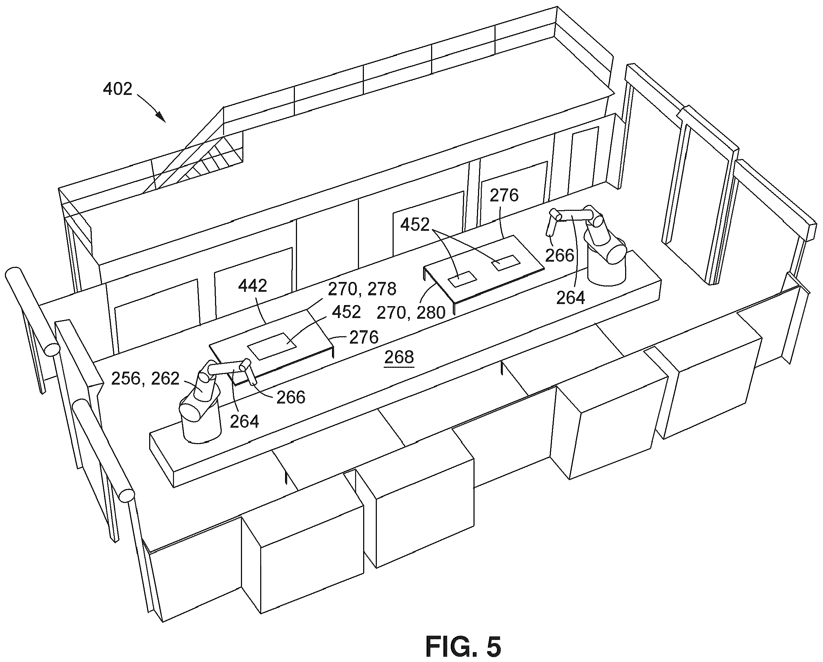

As mentioned above, the manufacturing cell 400 includes a plurality of processing stations 276, each of which is located proximate a worker 258. As shown in Figure 5, some of the robotic devices 262 of the manufacturing cell 400 include at least two processing stations 276, including a first processing station 278 and a second processing station 280. The first and second processing stations 276, 278 are each configured to support a workpiece 452 in fixed position relative to a worker 258. For example, each processing station 276 supports any one of the pallets 442 in fixed position relative to a robotic device 262 to allow the robotic device 262 to operate on the workpieces 452 supported on the pallet 442. In the present disclosure, a robotic device 262 is described as any device, machine, assembly, system, subsystem, and/or any type of equipment capable of autonomously performing one or more operations on a workpiece 452 when supported at a processing station 276. In this regard, a robotic device 262 is not limited to devices having one or more robotic arms 264 (e.g., Figure 6).

Referring to Figures 3-4, as mentioned above, the manufacturing cell 400 includes any number of AGVs 420 for transporting workpieces 452 between workpiece stations 270. In the example shown, each AGV 420 is configured to transport pallets 442 between workpiece stations 270. However, in other examples not shown, the AGVs 420 may be configured to transport workpieces 452 that are unsupported by pallets 442. Each AGV 420 is described as a robotic vehicle programmed to navigate the manufacturing cell 400 along predetermined AGV routes 424. The AGV routes 424 are made up of a plurality of route segments 426. The movement of the individual AGVs 420 along the AGV routes 424 is controlled by an AGV software module (not shown). The scheduling of the timing and order of movement of the AGVs 420 between workpiece stations 270 may be simulated by the presently-disclosed planning system 100 to arrive at a workpiece processing schedule that results in a high production throughput of workpieces 452.

Advantageously, the manufacturing cell 400 is configured to coordinate the operation of the AGVs 420 and the robotic devices 262 in a manner allowing each robotic device 262 to continuously operate on a workpiece 452 at a first processing station 278 of the robotic device 262, while the AGV 420 transfers another workpiece 452 (e.g., supported on a pallet 442) onto or off of the second processing station 280 of the same robotic device 262. In this regard, the robotic arms 264 (Figure 6) of the robotic device 262 continue to move and/or the end effector 266 (Figure 6) of the robotic device 262 made continue to operate on a workpiece 452 at the first processing station 278 while an AGV 420 loads or unloads a workpiece 452 (e.g., via a pallet 442) at the second processing station 280. The ability of robotic devices 262 to continue operating while workpieces 452 are loaded or unloaded increases the utilization of the robotic devices 262 and improves production throughput.

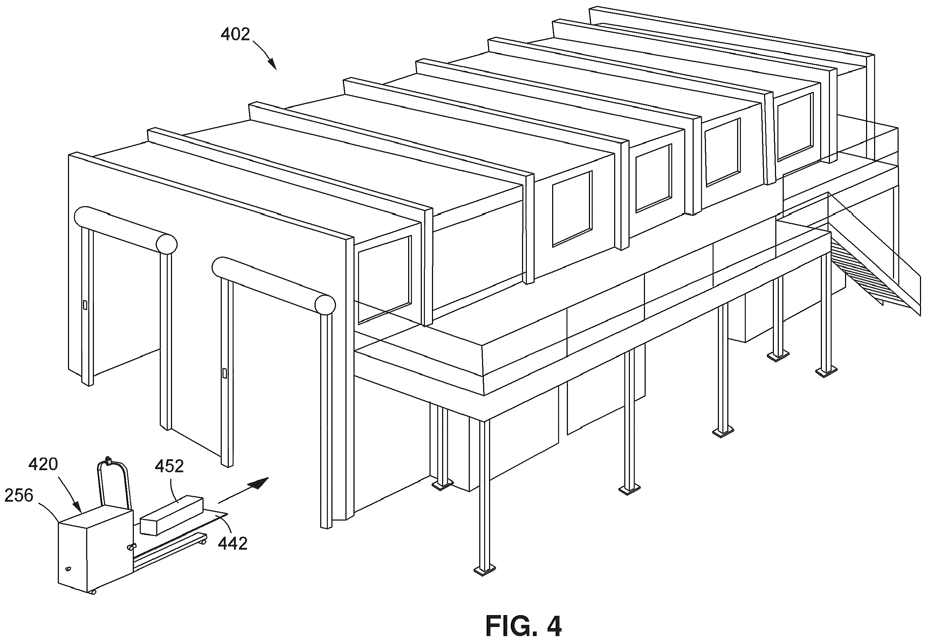

Referring to Figures 2-6, the manufacturing cell 400 may include one or more subcells for performing any one of a variety of different processes on the workpieces 452. In the example shown in Figures 2-3, the manufacturing cell 400 includes a machining subcell 402, an inspection subcell 404, and a cleaning subcell 406. Any one or more of the subcells may include one or more robotic devices 262 for performing operations on the workpieces 452. For example, Figures 4-6 show an example of a machining subcell 402 having a pair of robotic devices 262 mounted on a linear rail system 268 for expanding the work envelope of each robotic device 262. The robotic devices 262 in the machining subcell 402 are configured for machining, trimming, drilling, sanding, or performing other types of operations. The inspection subcell 404 includes one or more robotic devices 262 for inspecting the dimensions of a workpiece 452, such as after machining and/or after cleaning the workpiece 452.

In addition to subcells having robotic devices 262, the manufacturing cell 400 may include one or more subcells that are operated by technicians 260 (i.e., humans) instead of robotic devices 262. Each subcell operated by a technician 260 includes one or more processing stations 276 for supporting a workpiece 452. For example, the cleaning subcell 406 shown in Figures 2-3 has two cleaning booths 408 arranged side-by-side. Each cleaning booth 408 is operated by a technician 260, and includes a processing station 276 for supporting a pallet 442 upon which is mounted one or more workpieces 452 to be cleaned or washed by the technician 260. Although the manufacturing cell 400 is shown and described in the context of a machining subcell 402, an inspection subcell 404, and a cleaning subcell 406, the manufacturing cell 400 may include any one a variety of different types of subcells, and is not limited to the subcell shown in the figures. The manufacturing cell 400 may have subcells (not shown) for performing additional manual processes, such as deburring of workpieces 452, visual inspection of workpieces 452, and other manual operations. In other examples, the manufacturing cell 400 may be devoid of subcells.

Referring to Figures 6-9, the manufacturing cell 400 may include a station frame 440 at each workpiece station 270 as shown in Figure 7. Each station frame 440 may be removably mounted to the floor of the manufacturing cell 400. As shown in Figure 8, the station frame 440 at each workpiece station 270 is configured to receive a pallet 442 from an AGV 420. As shown in Figure 6, the workpiece 452 may be supported on a workpiece mounting fixture 446 which is fastened or otherwise fixedly attached to the pallet 442. Each workpiece mounting fixture 446 has a mounting surface 447 which may be contoured complementary to the contour of the workpiece 452. The mounting surface 447 may contain a plurality of apertures 448 fluidly coupled to a vacuum pressure source (not shown) for vacuum coupling of the workpiece 452 to the mounting surface 447 to prevent movement of the workpiece 452 when operated on by a worker 258 and when transported by an AGV 420.

Referring to Figure 9, shown is an example of an AGV 420 engaging a pallet 442 that is supported on a station frame 440 at a workpiece station 270. In the example shown, the AGV 420 has a pair of vertically movable AGV forks 422. The AGV forks 422 are shown inserted into a pair of fork tubes 444 of the pallet 442 for raising and lowering the pallet 442 onto and off of the station frame 440. In an alternative example, the AGVs 420 may be configured as non-forked AGVs (not shown) each having a low profile to allow the AGV to move underneath a station frame 440, and then raise upwardly for lifting the pallet 442 off of the station frame 440, and then translating the pallet 442 away from the station frame 440 and toward another workpiece station 270.

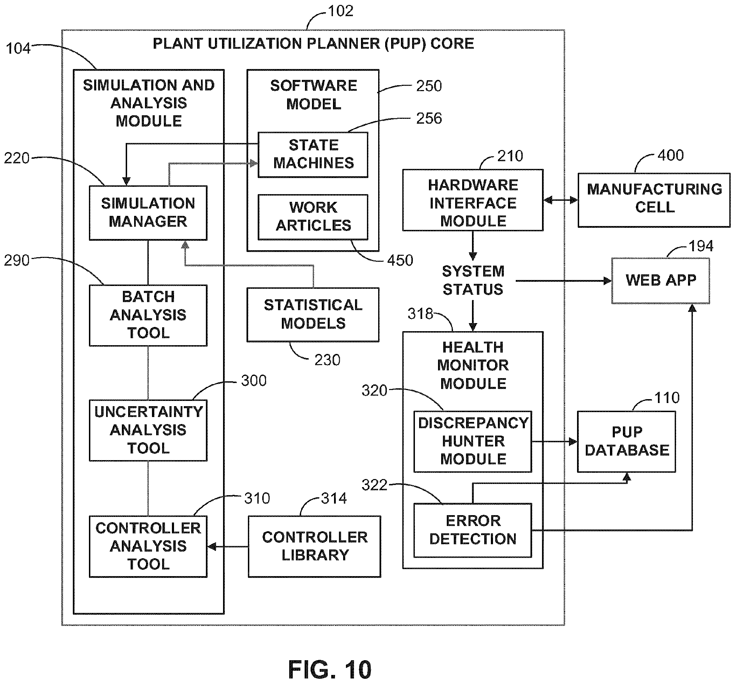

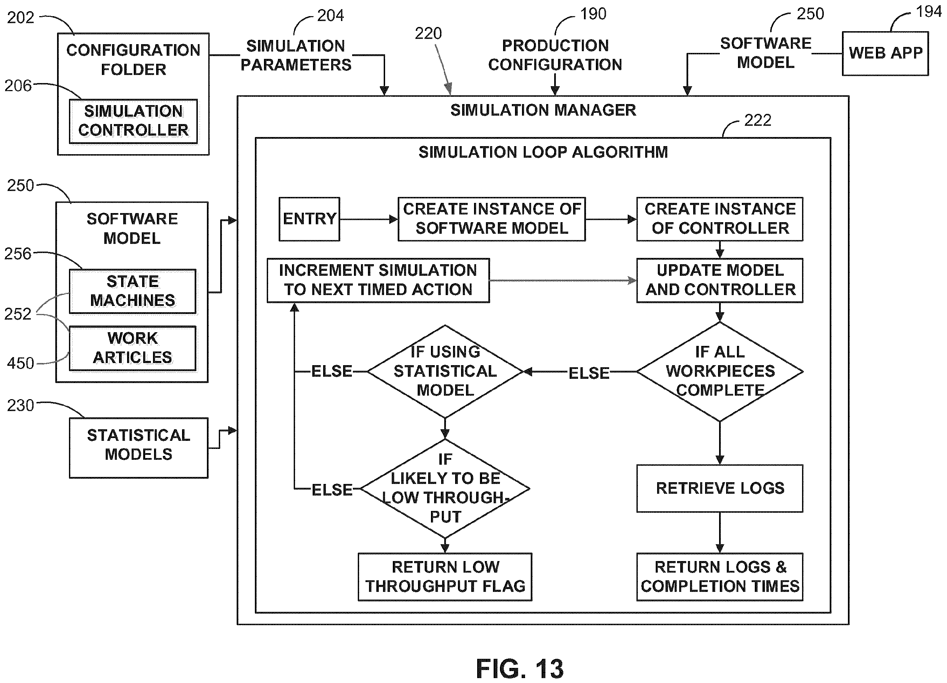

Referring back now to Figure 1 after describing the example machining cell 400, the presently-disclosed planning system 100 will now be described in greater detail. The planning system 100 includes the above-mentioned PUP core 102, and may include a plurality of user interfaces 120 communicatively coupled to the PUP core 102. The user interfaces 120 facilitate user entry of simulation parameters 204 (Figure 13) into the simulation and analysis module 104, and also facilitate user entry of worker schedules, and user entry of availability dates and completion dates of the workpieces 452 (Figure 12) listed in the production configuration 190 (Figure 13), which is described as a list of all workpieces 452 to be processed by the manufacturing cell 400 during a predetermined time period (e.g., a day, an 8-hour shift, etc.). As described in greater detail below, the user interfaces 120 are configured to display upcoming tasks to be performed by workers 258 (e.g., technicians 260 and robotic devices 262 - Figures 2-3), and may generate alerts of potential health issues of the manufacturing cell 400 during operation. In addition, the user interfaces 120 display proposed changes to modelled parameters of the software model 250 (Figure 10) based on discrepancies with real-time performance of the manufacturing cell 400, and facilitate user adjustment of the modelled parameters to better reflect real-time performance of the manufacturing cell 400.

In the example shown, the user interfaces 120 may include an engineering interface 122, a production control interface 124, a cell lead interface 126, a process station interface 128, a mobile interface 130, and/or a factory display 140. The engineering interface 122 allows an engineering user 172 (e.g., a programmer) to enter user inputs for setting up simulations for processing a plurality of workpieces 452, arranged in a specific order (i.e., a workpiece order). The engineering interface 122 allows the engineering user 172 to select the configuration files to be used when a simulation is run. The configuration files reside in a configuration folder 202 in the configuration data module 200 of the PUP core 102. The configuration files includes data that defines the workpieces 452 and the manufacturing cell 400 to be simulated. For example, the configuration folder 202 may contain separate configuration files respectively defining the workers 258 (Figures 2-3), the station layouts, the pallets 442 (Figures 2-3), the workpieces 452 (Figures 2-3), the processes (i.e., timed actions) to be performed on each workpiece 452 and the duration of each timed action, the definition of the AGVs 420, the AGV routes 424 (Figure 3), the route segments 426 (Figure 3), the AGV transit times along the AGV routes 424, and the simulation parameters 204 (Figure 13).

The worker file (not shown) describes human workers (e.g., technicians 260) and machine workers (e.g., robotic devices 262) of the manufacturing cell 400. The description of the workers 258 (Figures 2-3) includes a description of how each worker 258 behaves in the manufacturing cell 400. For example, the worker file describes the type of work (i.e., the timed actions) to be performed by each worker 258, and the amount of time required to perform each timed action. The worker file also includes a description of scheduled downtime for each worker 258, such as scheduled rest breaks for technicians 260 and/or routine scheduled maintenance for robotic devices 262, AGVs 420, and other equipment. In this manner, the simulation can determine when to assign a task to each worker 258, and when to allow for scheduled downtime for each worker 258. In addition to defining the amount of time required to perform each timed action, the worker file defines the expected maximum variability (e.g., expressed in percentages) in the amount of time required to perform each timed action. As described below, the maximum variability of timed actions is used in an uncertainty analysis for evaluating the robustness of a simulation of a workpiece order.

The station layout file (not shown) contains properties that fully describe each workpiece station 270 (Figures 2-3) in the manufacturing cell 400. For example, the station layout file defines the relative location of each workpiece station 270 in terms of X and Y coordinates. The station layout file also defines the type of work that occurs at each workpiece station 270, and the amount of time required for an AGV 420 to transfer a workpiece 452 (or a pallet 442) onto or off of each workpiece station 270. In addition, the station layout file defines the expected maximum variability of each transfer time.

The AGV file (not shown) defines AGV properties that are important to a simulation. For example, for each AGV 420 (Figures 2-3), the AGV file defines the battery life of the AGV 420, the discharge rate of the AGV battery when the AGV 420 is stationary, the discharge rate when the AGV 420 is in transit, and the location where each AGV 420 starts and ends each day or shift. The route segments file (not shown) contains the X and Y coordinates of the endpoints of each linear route segment 426 (Figure 3) in a floor map of the manufacturing cell 400, along with the amount of time required for an AGV 420 to travel each route segment 426. The AGV route file (not shown) describes the route segments 426 that the AGV 420 must travel in order to move from one workpiece station 270 (Figures 2-3) to another workpiece station 270. The workpiece file (not shown) defines the processes (e.g., the timed actions) that are to be performed on each workpiece 452 while in the manufacturing cell 400, and the amount of time required to perform each timed action. The pallet file (not shown) describes which workpieces 452 can be mounted on each pallet 442.

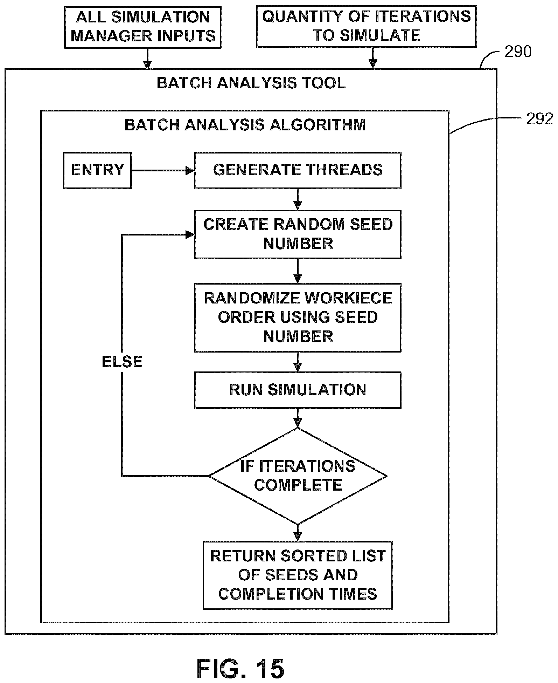

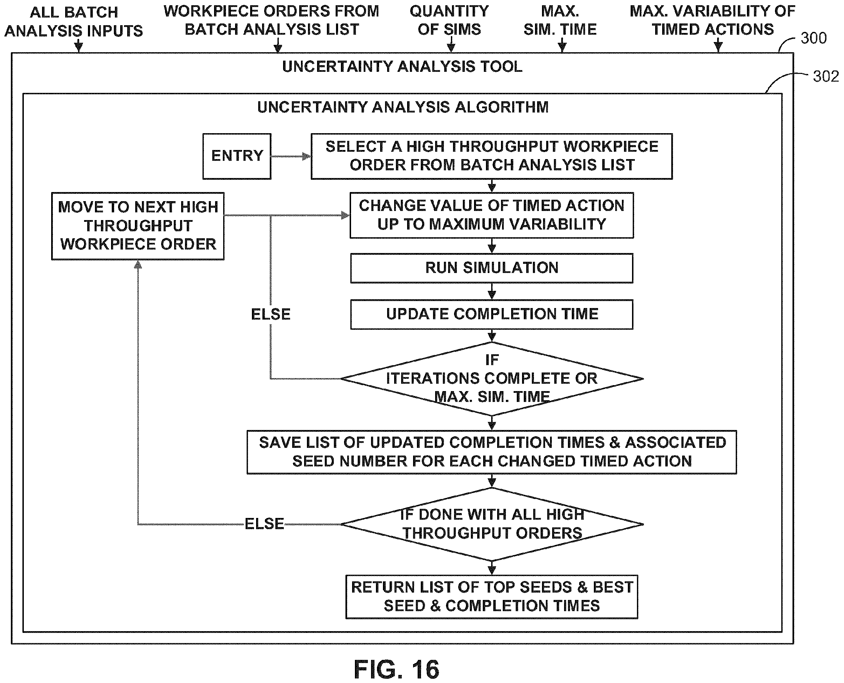

The simulation parameters file (not shown) contains all of the options for performing a simulation using the PUP core 102. For example, the simulation file may include a drop-down menu for selecting the type of simulation to run. Options for simulation types including performing a single simulation (Figure 13) of a workpiece order, performing a batch analysis (Figure 15) of multiple workpiece orders, performing an uncertainty analysis (Figure 16) for evaluating the effects of variances in the duration of timed actions, or performing a simulation from a configuration file. In addition to providing options for the type of simulation to run, the simulation file provides the user 170 with the ability to select which simulation controller 206 to use for running a simulation. As described below, each simulation controller 206 has a pre-programmed set of rules for determining the order in which the timed actions are performed on the workpieces 452 in a workpiece order. The simulation file also provides a user 170 with the ability to select the quantity of workpiece orders to be simulated, the maximum runtime of the simulation, the completion time threshold for distinguishing a good workpiece order (i.e., short completion time) from a bad workpiece order (i.e., long completion time), and a variety of other simulation parameters 204 (Figure 13).

Referring still to Figure 1, the planning system 100 may include a production control interface 124 for providing a production controller 174 (i.e., a human) with the ability to interface with the PUP core 102. For example, the production control interface 124 allows the production controller 174 to use a web application 194, referred to herein as a web app 194 (Figure 10), to upload a job description list (JDL) and an exceptions list. The JDL may be described as a full factory-scale schedule document listing every workpiece 452 that is going through the factory, and all the processes that must be performed on each workpiece 452. In addition, the JDL indicates the status of each process within the factory (i.e., the scheduled/actual start date of each process, and the scheduled/actual end date of each process). The exceptions list provides the production controller 174 with the ability to override the JDL if the JDL contains known inaccuracies. Once a JDL is uploaded to the PUP core 102 via the web app 194, the PUP core 102 parses the JDL and the exceptions list to generate a production configuration 190.

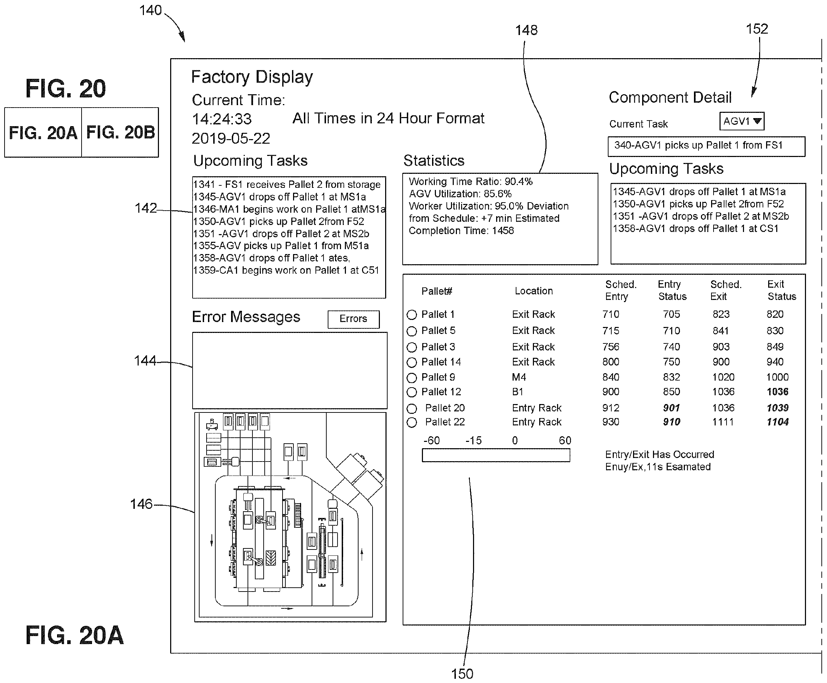

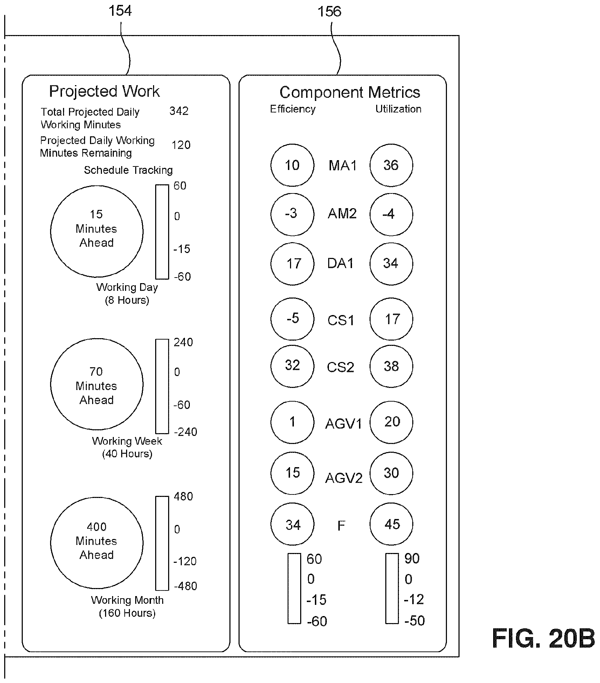

The PUP core 102 is configured to determine, via the JDL, the current status of each workpiece 452 in the factory to generate an estimate of when each workpiece 452 will be ready to enter the manufacturing cell 400. In addition, the PUP core 102 checks the scheduled start dates of the factory processes to be performed on each workpiece 452 after passing through the manufacturing cell 400 to determine the date and/or time when each workpiece 452 must be completed by the manufacturing cell 400. The production control interface 124 is configured to allow the production controller 174 to review and approve of the production configuration 190, and also allows the production controller 174 to command the PUP core 102 to begin a simulation of the production configuration 190, resulting in a long-term build plan. A long-term build plan contains all of the information in the production configuration 190, and additionally includes the estimated manufacturing cell 400 entry date/time and exit date/times of each workpiece 452. The production control interface 124 allows the production controller 174 to approve the long-term build plan for use by the below-described cell lead interface 126. In addition, the production control interface 124 functions as an interface with the below-described health monitor module 318 and the hardware interface module 210 of the PUP core 102, and additionally provides a live view (e.g., Figure 20) of operations occurring in the manufacturing cell 400 during the processing of a production configuration 190 of workpieces 452.

The planning system 100 may include a cell lead interface 126 for providing a cell leader 176 (e.g., a human) with the ability to view and approve of a daily build plan, which is a result of filtering the long-term build plan to include only workpieces 452 to be processed by the manufacturing cell 400 during a given time period (e.g., a day, a shift, etc.). More specifically, the daily build plan is a list of all workpieces 452 scheduled to be processed by the manufacturing cell 400 during the predetermined time period (e.g., a day, a shift, etc.), along with the estimated manufacturing cell 400 entry date/time and exit date/time for each workpiece 452. The cell lead interface 126 also provides the cell leader 176 with the ability to modify the daily build plan by removing specific workpieces 452, and relocating (i.e., bumping) such workpieces 452 (e.g., pallets 442) to the back of the schedule, resulting in a modified production configuration. The resulting modified production configuration is sent to the PUP core 102 for simulating to generate a new daily build plan having an optimized workpiece order. The cell lead interface 126 also allows the cell leader 176 to send an approved daily build plan to the hardware interface module 210.

The cell lead interface 126 serves as an interface with the PUP database 110, the health monitor module 318, and the hardware interface module 210 of the PUP core 102. The cell lead interface 126 displays the status of the physical components of the manufacturing cell 400, and also displays performance metrics of the physical components during operation. In addition, the cell lead interface 126 may provide a live view (e.g., Figure 20) of the manufacturing cell 400 during the processing of a workpiece order. The cell leader 176 may be responsible for the daily operation of the manufacturing cell 400. As mentioned above, the cell leader 176 may have the power to change the order in which certain workpieces 452 are processed by the manufacturing cell 400 (e.g., bumping workpieces 452 from the daily build plan), subject to approval by the production controller 174. The cell leader 176 may also be involved in assisting with certain manual tasks associated with the operation of the manufacturing cell 400, such as assisting in loading workpieces 452 onto and off of the feed stations 272.

The planning system 100 may include a process station interface 128 for providing each robot process operator 178 with the ability to interface with the health monitor module 318 and the hardware interface module 210. Similar to the production control interface 124 and the cell lead interface 126, the process station interface 128 provides the robot process operators 178 with a live view of the operations occurring in the manufacturing cell 400, including the operation of the robotic devices 262 (Figures 2-3). The planning system 100 may further include a mobile interface 130, which provides a manual forklift operator 180 with the ability to interface with the hardware interface module 210. The mobile interface 130 includes a display of the immediate tasks scheduled to be performed by each manual forklift. For example, the mobile interface 130 shows the upcoming destination (e.g., storage) of the forklift and the workpiece 452 or pallet 442 to be retrieved at that location. Furthermore, the mobile interface 130 shows the next destination of the manually-operated forklift, and where the workpiece 452 or pallet 442 should be delivered. In addition, the mobile interface 130 indicates the identity of the workpiece 452 or pallet 442 currently loaded on the manually-operated forklift. The planning system 100 also includes a factory display 140 (e.g., Figure 20), which serves as an interface with the health monitor module 318 and the hardware interface module 210, and provides one or more users 172 with the ability to monitor the status and performance of the manufacturing cell 400.

Referring still to Figure 1, the planning system 100 includes the above-mentioned PUP core 102. As described above, the PUP core 102 includes a configuration data module 200 comprised of a configuration folder 202 containing the above-mentioned configuration files. In addition, the PUP core 102 includes a simulation and analysis module 104 which contains algorithms for simulating the manufacturing cell 400. As described in greater detail below, the simulation and analysis module 104 includes a simulation manager 220 for evaluating the impact of the ordering of the workpieces 452 (i.e., the workpiece order) on the completion time of the workpiece order. In addition, the simulation and analysis module 104 provides a means for estimating the impact that uncertainty in the duration of timed actions have on the completion time of a workpiece order. Furthermore, the simulation and analysis module 104 provides users 170 with the ability to evaluate the impact of individual simulation controllers 206 on the completion time for processing a workpiece order, as described below. After completing one or more simulations of the manufacturing cell 400, the simulation and analysis module 104 outputs a top-performing workpiece order for a given workpiece order. A top-performing workpiece order has the shortest completion time for processing every workpiece 452 in the production configuration 190.

The planning system 100 includes a hardware interface module 210 communicatively coupling the PUP core 102 to the manufacturing cell 400. The hardware interface module 210 functions as a software link between the PUP core 102 and the manufacturing cell 400 via a shared control database 212 and a shared status database 214. The hardware interface module 210 transmits the workpiece order from the PUP core 102 to the manufacturing cell 400, and initiates production of the workpiece order upon user command, as described below. In addition, the hardware interface module 210 provides inputs needed by the physical components (e.g., robotic devices 262, workpiece stations 270, station frames 440, AGVs 420, automated equipment, etc.) of the manufacturing cell 400 for performing all of the required operations for processing workpieces 452. Furthermore, the hardware interface module 210 provides a means for inputting parameters that control the manner in which workpieces 452 move through the manufacturing cell 400. In addition, as mentioned above, the hardware interface module 210 continuously queries the manufacturing cell 400 for real-time data regarding control parameters of the physical components, and actively captures and record such data. The data is fed into and processed by the PUP core 102 to allow the simulation controllers 206 to make decisions based on the current state of the manufacturing cell 400. The hardware interface module 210 also transmits updates to control commands generated by the PUP core 102.

As shown in Figure 1, as mentioned above, the planning system 100 may include a health monitor module 318 as described in greater detail below. The health monitor module 318 is configured to monitor the performance of the manufacturing cell 400, and predicts and/or prevent failures that may otherwise result in production stoppage. Data from the health monitor module 318 is used for updating one or more modeled parameters of the software model 250 for improving the accuracy of simulations. The planning system 100 also includes a PUP database 110 for tracking information describing the processing of workpieces 452 by the manufacturing cell 400. In addition, the PUP database 110 saves the history of certain events such as production configurations 190, build plans, and changes to the modeled parameters of the software model 250.

Referring to Figure 10, shown is an example of the PUP core 102 having the above-mentioned simulation and analysis module 104. In addition, the PUP core 102 includes the software model 250 of the manufacturing cell 400, a controller library 314, statistical models 230 based on previous simulations, and the above-mentioned hardware interface module 210 and health monitor module 318. The simulation and analysis module 104 includes a simulation manager 220, and may additionally include a batch analysis tool 290, an uncertainty analysis tool 300, and a controller analysis tool 310, described below.

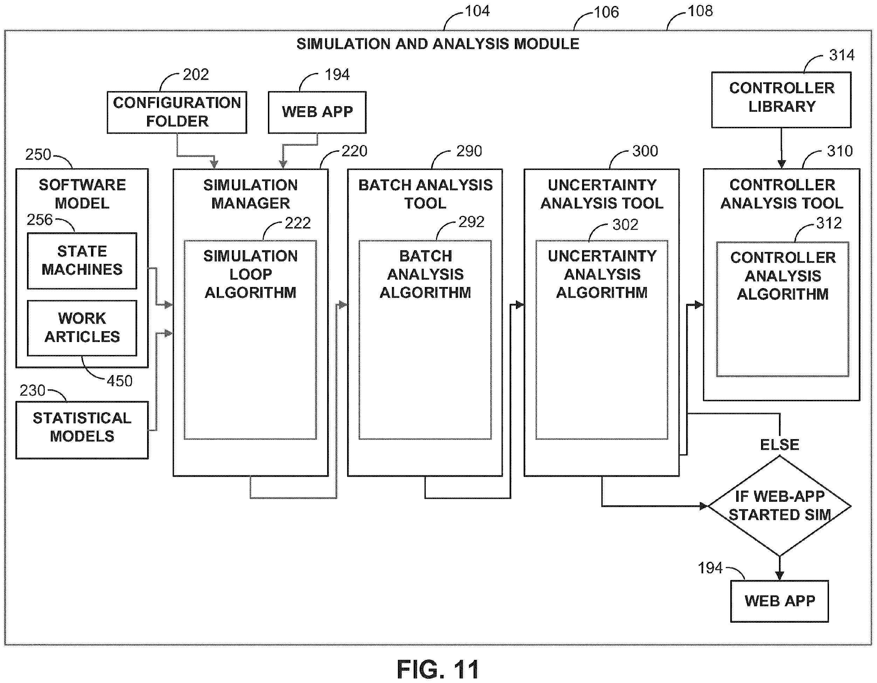

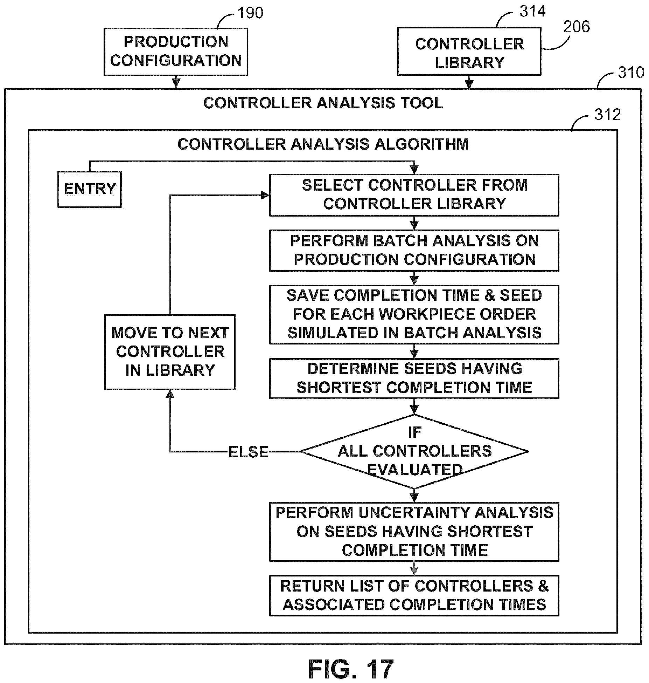

Referring to Figure 11, shown is an example of the simulation and analysis module 104 which has a processor 106, and a memory 108 storing instructions that, when executed by the processor 106, cause the simulation and analysis module 104 to perform as the simulation manager 220. In addition, execution of the instructions in the memory 108 cause the simulation and analysis model to perform as the batch analysis tool 290 (Figure 15), the uncertainty analysis tool 300 (Figure 16), and/or as the controller analysis tool 310 (Figure 17), each of which is described in detail below.

Referring to Figure 12, shown is a block diagram of an example of a software model 250 of the manufacturing cell 400. The software model 250 is made up of model components 252 configured to represent the physical components of the manufacturing cell 400. The model components 252 of the software model 250 include one or more state machines 256 and/or one or more work articles 450. Each state machine 256 is configured to perform one or more timed actions on the work articles 450. In one example, the state machines 256 include workers 258, workpiece stations 270, AGVs 420, and may include other automated equipment. The work articles 450 include workpieces 452, and further include pallets 442 for supporting the workpieces 452. Each workpiece 452 has a workpiece configuration that is defined in the workpiece file. As mentioned above, the pallet file describes which workpieces 452 can be mounted on each pallet 442.

The workers 258 include technicians 260 (e.g., human workers) and/or robotic devices 262 (e.g., machine workers), as shown in Figures 2-3. The timed actions performed by the workers 258 include operating on the workpieces 452 when the workpieces 452 are loaded onto the workpiece stations 270. As mentioned above, the worker file describes the timed actions performed by each worker 258, and the amount of time required to perform each timed action. The workpiece file defines the type of timed actions that are required to be performed on each workpiece 452 while in the manufacturing cell 400, and the order in which the timed actions must be performed on each workpiece 452. Examples of timed actions include a machining operation performed by a robotic device 262 in the machining subcell 402 (Figure 2), a cleaning operation performed by a technician 260 in the cleaning subcell 406 (Figure 2), and/or an inspection operation performed by a robotic device 262 in the inspection subcell 404 (Figure 2).

The timed actions performed by the AGVs 420 include autonomously transporting the workpieces 452 (e.g., via the pallets 442) between the workpiece stations 270 (Figures 2-3), including between processing stations 276, buffer stations 274, and/or feed stations 272. Each AGV 420 is commanded by a manufacturing cell controller (not shown) to pick up and drop off workpieces 452 at the different workpiece stations 270. The software model 250 includes a transit map module 254 that may be shared by all AGVs 420. The transit map module 254 is used to determine the transit time between different workpiece stations 270 within the manufacturing cell 400. In addition, the transit map module 254 tracks when individual route segments 426 are in use to avoid collisions between AGVs 420. The transit map module 254 is also configured to account for collision avoidance pauses in the movement of the AGVs 420 when determining the total transit time of an AGV 420 between workpiece stations 270.

The manufacturing cell 400 and software model 250 may include one or more idle stations 428 (Figure 3) along the AGV routes 424 (Figure 3). Each idle station 428 is defined as a location where an AGV 420 can go for recharging the AGV battery. During manufacturing cell operations, if an AGV 420 currently has no new assignment after the AGV battery is finished charging, the AGV 420 may wait at the idle station 428 until assigned a new task.

Referring still to Figure 12, each state machine 256 has a defined state respectively during and between timed actions, and a defined state transition from state to state. For example, a worker 258 has four possible states, including "idle," "working," "down," and "inactive." In the "idle" state, the worker 258 is not currently in action, and may be ready to begin a new operation on a workpiece 452 mounted at one of its workpiece stations 270. In the "working" state, the worker 258 is in progress on an operation on a workpiece 452. In the "down" state, the worker 258 may be down for routine reasons, such as routine maintenance, cleaning, or tool (e.g., end effector) replacement. In the "inactive" state, the worker 258 is non-operational due to an unexpected event, such as a failure of the worker 258 (e.g., robotic device 262) or due to an emergency stop.

Each worker 258 also has state transitions between states. For example, a worker 258 has a state transition of "begin work" which represents the transition of the worker 258 from "idle" to "working," and which may be triggered by the workpiece station 270 upon receiving a workpiece 452 from an AGV 420. A worker 258 also has a state transition of "begin downtime" which represents the transition of the worker 258 from "idle" to "down,", and which may be triggered by the worker 258 itself when there is no longer enough time to complete the next task before the start of the following task. A worker 258 also has a state transition of "complete downtime" which represents the transition of the worker 258 from "down" to "idle," and which may be automatically triggered by the worker 258 when the required downtime has elapsed. A worker 258 also has a state transition of "release" which represents the transition of the worker 258 from "working" to "idle." In addition, a worker 258 has a state transition of "go inactive," and which may be triggered by the simulation controller 206 (Figure 13).

The AGVs 420 also have states and state transitions. For example, an AGV 420 has the states of "idle," "charging," "transiting/unload," "waiting/pickup," "picking up," "transiting/loaded," "waiting/drop off," and "dropping off." State transitions for the AGVs 420 include "move," representing the transition from "idle" to "transiting/unloaded" or the transition from "idle" to "transiting/loaded." In addition, state transitions between "idle" and "charging" include "charge" and "hold." Other state transitions for the AGVs 420 include "wait for pickup," "pickup," "complete pickup," "wait for drop off," "drop off," and "complete drop off." The above-noted state transitions for the AGVs 420 may be triggered by the simulation controller 206, or the state transitions may be triggered by the AGV 420 upon arrival at a workpiece station 270, upon loading or unloading a workpiece 452 at a workpiece station 270, or by other events.

The workpiece stations 270 also have states and state transitions. For processing stations 276 located near a worker 258, examples of states include "available," "unloaded/expecting," "loaded/waiting," "loaded/working," "loaded/complete," and "loaded/expecting." Examples of state transitions between the above-mentioned states for the processing stations 276 include "assigned pallet," "load pallet," "begin work," "in work," "expect AGV," and "unload pallet." The above-noted state transitions for the processing stations 276 may be triggered by an AGV 420 (e.g., loading or unloading a workpiece), by the processing station 276 (e.g., upon completion of a timed action by a worker), and/or by the simulation controller 206. The feed stations 272 also have states and state transitions. For example, the feed stations 272 include states of "available," "expecting/new pallet," "loaded/new pallet," "loaded/new pallet," "loaded/AGV enroute," "expecting/completed pallet," "loaded/completed pallet," and "unloading/completed pallet." Examples of state transitions between the above-mentioned states for the feed stations 272 include "assigned new pallet," "load new pallet," "expect AGV," "unload new pallet," "assign completed pallet," "load completed pallet," "unload completed pallet," and "demold completed pallet."

Referring to Figure 13, shown is an example of the simulation manager 220 which is configured to run a single simulation for a given manufacturing cell 400 configuration, production configuration 190, and simulation controller 206. The simulation manager 220 is configured to receive simulation manager inputs, which include the software model 250 and the production configuration 190. As indicated above, the production configuration 190 is a list of workpieces 452 to be processed by the manufacturing cell 400. Each workpiece 452 in the production configuration 190 has one of the workpiece configurations defined in the software model 250.

The simulation manager 220 is a submodule of the simulation and analysis module 104, and includes a simulation loop algorithm 222 configured to simulate the processing of the workpieces 452 in a workpiece order. As indicated above, the workpiece order is the order in which the timed actions are performed on the workpieces 452 in the production configuration 190. The simulation includes creating, at initiation of the simulation, an instance of the software model 250 and an instance of the simulation controller 206. As mentioned above, the simulation controller 206 has a pre-programmed set of rules for determining the order in which the timed actions are performed on the workpieces 452 in the workpiece order. The pre-programmed set of rules is an ordered list of the priority of each timed action to be performed on the workpieces 452. For example, the simulation controller 206 may give priority to performing a machining operation on a workpiece 452 over cleaning the workpiece 452 or inspecting the workpiece 452. In another example, the simulation controller 206 may give priority to sending an AGV 420 to an idle station 428 to recharge a low AGV battery over sending the AGV 420 to a feed station 272 to pick up a workpiece 452. The simulation controller 206 may also determine which of the workpiece stations 270 is more important to unload first, how many new workpieces 452 can be loaded at one time at the feed stations 272, and any one of a variety of other decisions that determine the order in which timed actions are performed by the manufacturing cell 400 when processing the workpieces 452 in the production configuration 190.

Referring still to Figure 13, after creating the instance of the software model 250 and simulation controller 206, the simulation process includes determining the next timed action to be performed by the state machines 256, and incrementing the simulation to the next timed action. The simulation further includes updating the software model 250 and the simulation controller 206 each time one of the state machines 256 performs a timed action, and recording the state transitions associated with the timed action. The simulation includes repeating the steps of determining the next timed action, incrementing the simulation, and updating the software model 250 and the simulation controller 206, until all of the workpieces 452 in the workpiece order have been processed. After performing the above-noted steps, the simulation manager 220 outputs a simulated completion time for processing the workpiece order. In addition, the simulation manager 220 outputs a state transition log of all of the state transitions recorded for each state machine 256 during the processing of the workpieces 452 in the workpiece order. Advantageously, the simulated completion time and state transition logs provide an indication of the production efficiency of the manufacturing cell 400, and aid in making design decisions such as decisions regarding the physical layout of the workers 258 in the machining cell, worker scheduling, and decisions on the timing and extent of future factory expansion.

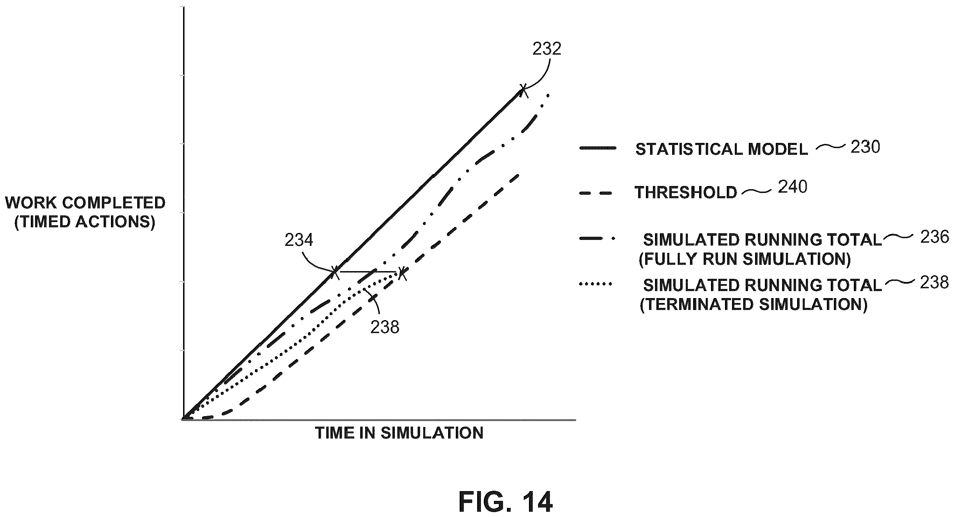

Referring to Figure 13-14, in some examples, the simulation and analysis module 104 may include a statistical model 230 for determining, during a simulation, if the simulation is likely to perform poorly (e.g., a low-throughput workpiece order) and, if so, terminating the simulation prior to completion. More specifically, a statistical model 230 provides a means for estimating the quantity of work (i.e., the quantity of timed actions) remaining to be performed on a workpiece order during the processing of the workpiece order by the manufacturing cell 400. The statistical model 230, represented by the solid line in the graph of Figure 14, includes a best-case completion time 232 of the workpiece order. The best-case completion time 232 is represented by the upper right-hand endpoint of the solid line. The statistical model 230 includes a threshold 240 beyond which a simulation is terminated. In the graph of Figure 14, the threshold 240 is represented by the medium-dashed line. The best-case completion time 232 for a workpiece order is determined via a multiple linear regression that is fit to a variety of statistical model parameters of a plurality of previously-performed simulations. The statistical model parameters of such previously-performed simulations includes the quantity of workpieces 452 in a workpiece order, the mean of the timed actions in the production configuration, and the standard deviation of the timed actions in the production configuration.

For examples of the simulation manager 220 that incorporate statistical models 230 (Figure 13), the simulation manager 220 continuously evaluates the status of a simulation prior to simulating all of the workpieces 452 in the workpiece order. The status of a simulation is evaluated following each update of the software model 250, by adding the duration of the most recently completed simulated timed action to a running total of the duration of the simulated timed actions performed up to the most recent update of the software model 250. The evaluation further includes determining, at that point in the simulation (i.e., at the same quantity of timed actions in the statistical model 230 as in the simulation), the statistically-modeled best-case interim time 234, which is calculated as a function of the statistically-modeled best-case completion time 232 and the sum of the duration of every timed action required to complete the workpiece order. The evaluation also includes calculating the difference between the statistically-modeled best-case interim time 234 to the running total of the duration of the simulated timed actions, and terminating the workpiece order simulation (i.e., return low-throughput flag) if the difference is greater than 50 percent of the best-case interim time 234. The dotted curve in Figure 14 represents the running total of the duration of the timed actions of a terminated simulation 238. The phantom curve in Figure 14 represents the running total of the duration of the timed actions of a fully run simulation 236.

Referring to Figure 15, shown is an example of the above-mentioned batch analysis tool 290, which is a submodule of the simulation and analysis module 104. The batch analysis tool 290 includes a batch analysis algorithm 292 configured to run a series of simulations of the same production configuration 190 of workpieces 452. Prior to each simulation, the production configuration 190 is randomized into a different workpiece order. The batch analysis tool 290 is configured to receive batch analysis inputs, which include the simulation manager inputs provided to the simulation manager 220. In addition, the batch analysis inputs include the quantity of iterations of the workpiece order to simulate, and may optionally include the quantity of threads (not shown) of the processor 106 to run the simulations on.

The process of performing a batch analysis includes creating a random seed number, and randomizing the workpiece order by arranging the workpieces 452 of the production configuration 190 into a different ordering than previously simulated using a random number generator initialized with the random seed number. The batch analysis process includes associating the randomized workpiece order with the seed number. By creating a seed number to represent each workpiece order, memory and simulation processing requirements are reduced. After randomizing the workpiece order, the batch analysis process includes performing, using the simulation manager 220, a simulation of the randomized workpiece order as shown in the above-described Figure 13. The batch analysis process includes repeating the steps of creating a random seed number, randomizing the workpiece order, and performing a simulation of the randomized workpiece order, until all of the quantity of iterations have been completed. The batch analysis process additionally includes outputting a batch analysis list of the seed numbers and corresponding simulated completion time for each of the randomized workpiece orders. The workpiece order having the shortest completion time may be selected for running the manufacturing cell 400 for processing the actual workpieces 452.

During each simulation performed in a batch analysis, the process may optionally include the use of statistical models 230 (Figures 13-14 to evaluate the status of each simulation, and terminating a simulation early (prior to completion) if the running total of the duration of the timed actions exceeds a predetermined threshold 240 relative to a statistically-modeled best-case interim time 234, as described above and shown in Figure 14. In addition, statistical models 230 may be used in a batch analysis to terminate simulations upon identifying a predetermined quantity (e.g., at least two) of workpiece orders that have acceptable completion times. An acceptable completion time of a workpiece order may be described as a completion time that is within 50 percent of the statistically-modeled best-case completion time 232.

Referring to Figure 16, shown is an example of the above-mentioned uncertainty analysis tool 300, which is described as another submodule of the simulation and analysis module 104. As mentioned above, the uncertainty analysis tool 300 is used to evaluate the effects of variances in the duration of timed actions performed by the state machines 256, on the amount of completion time required to process all of the workpieces 452 in a production order. As described above, the state machines 256 include workers 258 (e.g., human workers and machine workers), workpiece stations 270, AGVs 420, and other production equipment in the manufacturing cell 400. The uncertainty analysis tool 300 is configured to receive the batch analysis inputs, and re-simulate the top-performing workpiece orders, applying uncertainty to the simulation manager 220. For example, the uncertainty analysis tool 300 re-simulates at least two of the randomized workpiece orders from the batch analysis list. The randomized workpiece orders selected from the batch analysis list each have a simulated completion time that is shorter than the simulated completion time of the remaining randomized workpiece orders evaluated by the batch analysis.

The uncertainty analysis tool 300 is configured to receive all of the batch analysis inputs, and also receive the workpiece orders on the batch analysis list resulting from the batch analysis process. In addition, the uncertainty analysis tool 300 is configured to receive user-entered data, such as the quantity of iterations of the uncertainty analysis to perform on the workpiece orders selected from the batch analysis list. In addition, the uncertainty analysis tool 300 receives a user-entered maximum amount of simulation time to spend performing uncertainty analysis iterations on the workpiece orders selected from the batch analysis list. Furthermore, the uncertainty analysis tool 300 receives the maximum variability of at least one timed action of at least one of the state machines 256. As mentioned above, the configuration files includes the duration of each timed action performed by the state machines 256, and the maximum variability associated with each timed action. For example, the worker file lists the expected maximum variability (e.g., expressed in percentages) in the amount of time required for a robotic device 262 in the machining subcell 402 to perform a machining operation on a workpiece 452. In another example, the AGV file defines the expected maximum variability in the discharge rate of the AGV battery during each one of the above-mentioned AGV states.

As shown in Figure 16, the uncertainty analysis tool 300 includes an uncertainty analysis algorithm 302 configured to perform, on the randomized workpiece orders selected from the batch analysis list, an uncertainty analysis, by first selecting from the batch analysis list a plurality of high-throughput workpiece orders (i.e., each having a relatively short completion time). The uncertainty analysis includes changing the value of at least one timed action of at least one of the state machines 256 up to its maximum variability, performing a simulation (e.g., Figure 13) of the workpiece order, and updating the simulated completion time for the workpiece order as a result of the changed timed action. The uncertainty analysis process includes repeating, for every workpiece order, the steps of changing the value of at least one as-yet unchanged timed action of at least one state machine 256, performing the simulation of the workpiece order, and updating the simulated completion time until either completing the quantity of iterations of the uncertainty analysis, or reaching the maximum simulation time, whichever occurs first.

The uncertainty analysis process additionally includes saving a list of the updated simulated completion times of the workpiece order for each one of the changed timed actions. The updated simulated completion time of each workpiece order is associated or listed with the seed number that was generated for the workpiece order during the batch analysis. The uncertainty analysis process additionally includes determining the mean and the standard deviation of the updated simulated completion times of the workpiece order for each of the timed actions, and combining the mean and the standard deviation to create a composite score for the workpiece order.

Upon completing the uncertainty analysis for each one of the randomized workpiece orders selected from the batch analysis list, the uncertainty analysis tool 300 is configured to rank the workpiece orders, taking into account the mean and the standard deviation of the completion times. For example, the uncertainty analysis tool 300 may be configured to identify a plurality of top seeds of workpiece orders having a lower composite score than 90 percent of all of the workpiece orders subjected to the uncertainty analysis. The uncertainty analysis tool 300 is also be configured to identify, from among the top seeds, the best seed, which is the workpiece order having the lowest composite score. The uncertainty analysis tool 300 outputs an uncertainty analysis list containing the best seed, the top seeds, and the corresponding composite scores.

Referring to Figure 17, shown is an example of the above-mentioned controller analysis tool 310, which is another submodule of the simulation and analysis module 104. As mentioned above, the controller analysis tool 310 is used to evaluate the impact of individual simulation controllers 206 on the completion time for processing a workpiece order. Toward this end, the controller analysis tool 310 is communicatively coupled to a controller library 314 containing a plurality of simulation controllers 206, each having a different set of rules for determining the order in which timed actions are performed on workpieces 452. The controller analysis tool 310 includes a controller analysis algorithm 312 configured to perform a controller analysis to evaluate the effect of each one of the simulation controllers 206 on the completion time for processing the production configuration 190 of the workpieces 452.

The process of performing a controller analysis includes performing the above-described batch analysis (Figure 15) for simulating a plurality of workpiece orders of the production configuration 190, using one of the simulation controllers 206 previously unused in a simulation. In addition, the controller analysis process includes saving, for each workpiece order simulated via the batch analysis, the simulated completion time using the simulation controller 206, and the seed associated with each workpiece order. The controller analysis process then includes determining, for the simulation controller 206, the seeds for which the workpiece order has a shorter simulated completion time than 90 percent of all of the workpiece orders simulated using the simulation controller 206. The controller analysis process includes repeating, for each simulation controller 206 (i.e., until all simulation controllers 206 have been used in a batch analysis), the steps of performing the batch analysis, saving the simulated completion time and associated seed, and determining the seeds for the workpiece order having the shorter simulated completion time (e.g., shorter than 90 percent of the workpiece orders). The controller analysis process includes performing, for each simulation controller 206, the above-described uncertainty analysis (Figure 16) on each workpiece order that has the above-mentioned shorter simulated completion time. The controller analysis algorithm 312 may output a list of the simulation controllers 206 and corresponding composite scores, and which may facilitate the identification of the simulation controller 206 that results in the shortest simulated completion time for the production configuration 190. As mentioned above, the workpiece configuration having the shortest cement completion time may be selected for running the manufacturing cell 400 for processing the workpieces 452.

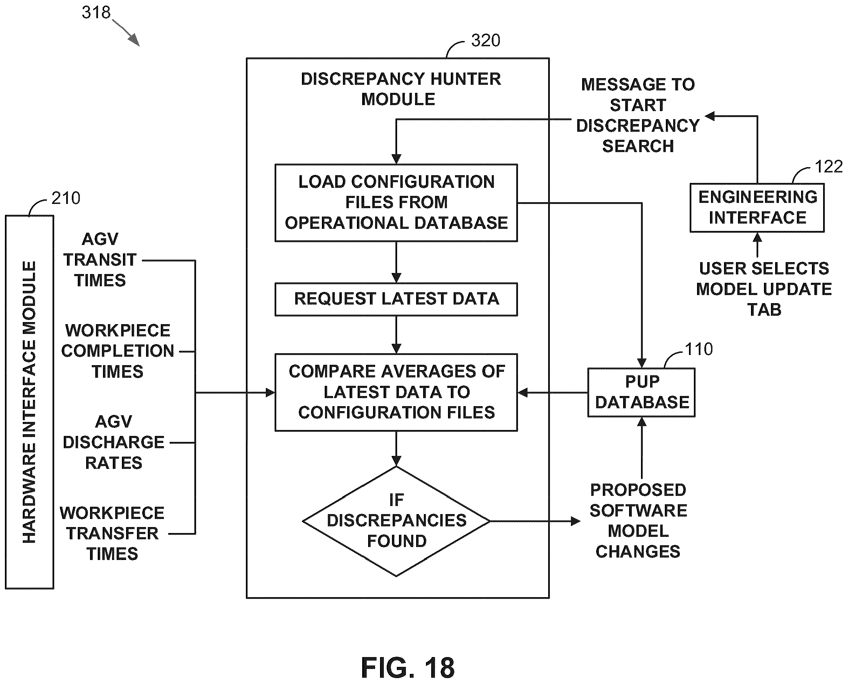

Referring to Figure 18, shown is an example of a discrepancy hunter module 320, which may be part of the above-mentioned health monitor module 318 that may be included with the PUP core 102. As shown in Figure 1, the health monitor module 318 is communicatively coupled to the manufacturing cell 400 via the hardware interface module 210. When commanded by a user 170 such as via the engineering interface 122, the discrepancy hunter module 320 is configured to monitor real-time performance of the manufacturing cell 400 during processing of a workpiece order. In this regard, the discrepancy hunter module 320 loads data from the configuration files defining the software model 250. In addition, the discrepancy hunter module 320 requests, from the hardware interface module 210, real-time performance data of various physical components of the manufacturing cell 400. For example, the requested data may include AGV transit times, workpiece completion times, AGV discharge rates, workpiece transfer times, and any one of a variety of other performance parameters. Upon receiving the requested data from the hardware interface module 210, the discrepancy hunter module 320 compares the most recently received data to the corresponding performance data of the software model 250. In this regard, the discrepancy hunter module 320 compares the real-time operating performance of the manufacturing cell 400 to predicted performance based on the simulation of the workpiece order in the software model 250.

The discrepancy hunter module 320 is configured to detect discrepancies between the real-time performance of the manufacturing cell 400 and the predicted performance based on the simulation. If discrepancies are detected, the discrepancy hunter module 320 may propose changes to one or more of the modeled parameters of the software model 250, which are stored in the PUP database 110. The changes to the software model 250 proposed by the discrepancy hunter module 320 may better reflect the real-time performance of the manufacturing cell 400. The user interfaces 120 include one or more features (e.g., an error button - Figure 20) that allow a user 170 to reject or accept any one of a number of proposed changes to the modeled parameters.

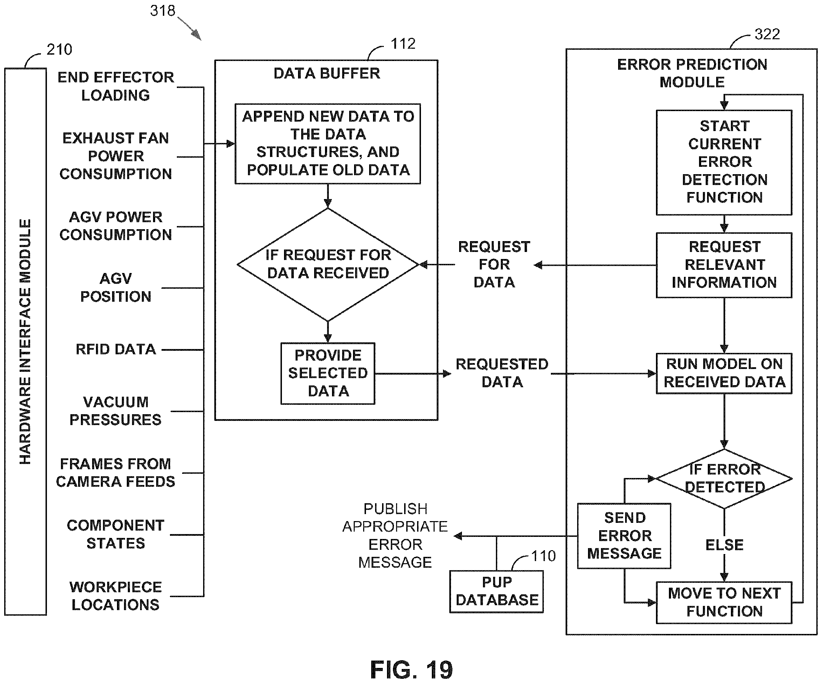

Referring to Figure 19, shown is an example of an error prediction module 322 that may be part of the above-mentioned health monitor module 318 of the PUP core 102. The error prediction module 322 is communicatively coupled to the manufacturing cell 400 via the hardware interface module 210 and a data buffer 112. The data buffer 112 is configured to receive requests for data from the error prediction module 322. For example, the error prediction module 322 requests data relevant to the performance of the AGVs 420. The data buffer 112 receives real-time performance data from the hardware interface module 210 regarding the performance of various physical components of the manufacturing cell 400. For example, the data buffer 112 continuously receives performance data regarding the loading of the end effectors 266 on the robotic devices 262, the power consumption of exhaust fans (not shown) in the manufacturing cell 400, the AGV power consumption and the current AGV locations within the manufacturing cell 400, RFID data identifying which pallets 442 are located on which workpiece stations 270, the magnitude of the vacuum pressure coupling the workpieces 452 to the workpiece mounting fixtures 446, the latest frames (e.g., images) from camera feeds (not shown) from different locations in the manufacturing cell 400, the current component states of the state machines 256 (e.g., workers 258, workpiece stations 270, AGVs 420, etc.), the current locations of the workpieces 452 in the manufacturing cell 400, and other data. Upon receiving the requested real-time performance data, the data buffer 112 appends the newly received data to data structures within the data buffer 112, and may overwrite obsolete data.

Referring still to Figure 19, upon receiving the requested data from the data buffer 112, the error prediction module 322 runs a model (e.g., a software program) on the requested data, which comprises comparing the real-time operating performance of the manufacturing cell 400 with nominal operating parameters and/or historical performance data recorded when the state machines 256 (e.g., robotic devices 262) of the manufacturing cell 400 were known to be operating correctly. The comparison performed by the error prediction module 322 identifies or detects errors in the operation of any of the physical components of the manufacturing cell 400. For example, the error prediction module 322 may include a vacuum error detection function (i.e., a software routine), configured to compare real-time vacuum pressure to a predetermined threshold value. In another example, the error prediction module 322 may include a robot loading error detection function, configured to compare the last several minutes of end effector loading data of a given robotic device, to historical performance data of other times the same robotic device was performing a similar operation on a workpiece.

In addition, the error prediction module 322 is configured to detect trends in one or more modeled parameters of the physical components in the manufacturing cell 400 based on discrepancies between the real-time performance and the simulated or historical performance. Upon detecting an error, or upon detecting a trend that may result in a failure within the manufacturing cell 400, the error prediction module 322 generates an error message, which is published on one or more of the user interfaces 120. For example, one or more of the user interfaces 120 may include an error message window 144 where errors or alerts may be displayed.

Referring to Figure 20, shown is an example of a factory display 140 having a display arrangement that is incorporated into any one or more of the above-described user interfaces 120. The factory display 140 provides a user 170, such as an observer 182, with an interface for the health monitor module 318 and the hardware interface module 210. The factory display 140 includes a tasks window 142 listing all of the tasks (i.e., timed actions) scheduled to be performed by the manufacturing cell 400 during a predetermined time period (e.g., a day, a shift, etc.). The timed actions may be listed in order of execution. In addition, as mentioned above, the factory display 140 includes an error message window 144, which may include an error button and/or a lamp configured to emit light in an appropriate color to indicate the absence or presence of errors in the manufacturing cell 400. For example, the error button may be green to indicate that no errors are present, yellow to warn of potential errors, and red to indicate the presence of existing errors in the manufacturing cell 400. In addition, the error button may be configured such that when depressed, detailed information describing the error may appear in the error message window 144.

The factory display 140 may also include a graphic 146 of the manufacturing cell 400, and which include displays or icons that represent in real time the physical components of the manufacturing cell 400. For example, the icons may include an icon representing each pallet 442 loaded onto a workpiece station 270 or being transported by an AGV 420. The state of the workers 258 in the manufacturing cell 400 may be represented by color-coded circles. For example, active workers may be represented as green circles, idle workers may be represented as yellow circles, and inactive workers may be represented by red circles. The factory display 140 further includes a statistics window 148 configured to display statistics or metrics describing the general health and performance of the manufacturing cell 400 for the predetermined time period (e.g., a day, an 8-hour shift, etc.) of operation.

The factory display 140 further includes include a status window 150 configured to show the status of all workpieces 452 and/or pallets 442 in the manufacturing cell 400. A color-coded circle may be located next to each workpiece 452 or pallet 442 to indicate whether the workpiece 452 or pallet 442 is ahead of schedule or behind schedule. In addition, the component detail window 152 indicates the physical location of each workpiece 452 or pallet 442 in the manufacturing cell 400. The factory display 140 further includes a component detail window 152 having a drop-down menu allowing the user 170 to select from any one or more of the physical components of the manufacturing cell 400 to view detailed information regarding the status of the physical component. Upon selecting a physical component from the drop-down menu, the component detail window 152 indicates the task currently being performed by the physical component (e.g., state machine 256) and all upcoming tasks. The factory display 140 also includes a schedule tracking window 154 configured to show the progress of the manufacturing cell 400 in comparison to the predicted schedule of operation. In addition, the factory display 140 includes an efficiency tracking window 156 configured to display an integer value representing the efficiency of each one of the state machines 256 (e.g., workers 258, AGVs 420, etc.) in the manufacturing cell 400. The efficiency of a state machine is calculated as the predicted total working time, minus the actual total working time of the state machine 256. In addition to displaying the efficiency, the efficiency tracking window 156 may display an integer value representing the utilization of each state machine 256, which may be defined in terms of the predicted total amount of time spent working, minus the actual time spent working.

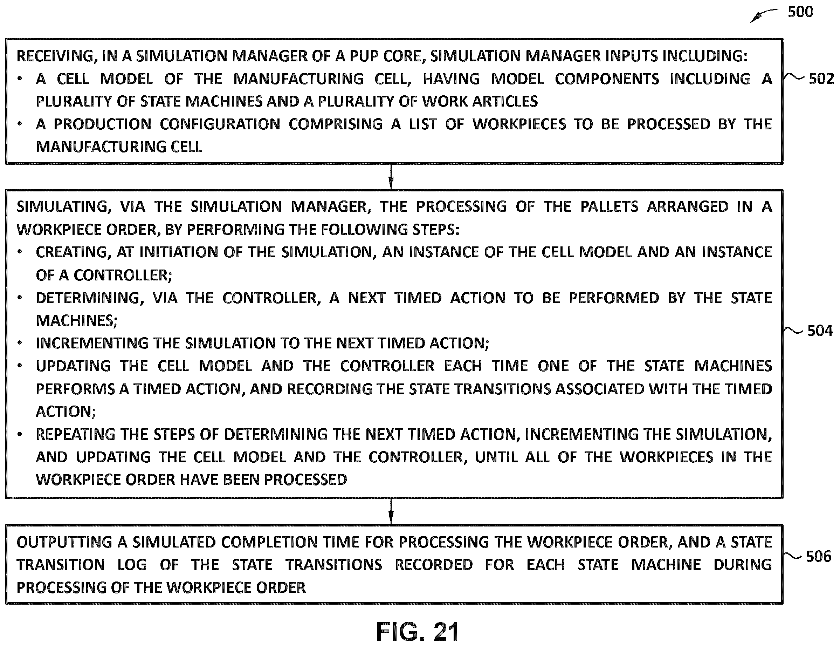

Referring now to Figure 21, shown is a flowchart of operations of a method 500 of simulating the processing of workpieces 452 by a manufacturing cell 400. The method includes step 502 of receiving, in the simulation manager 220, simulation manager inputs including a software model 250 of the manufacturing cell 400. The simulation manager inputs are entered into the simulation and analysis module 104 via one of the above-described user interfaces 120. For example, an engineering user 172 uses the engineering interface 122 to select the model components 252 of the software model 250 from the configuration files. As described above, the software model 250 has model components 252 including a plurality of state machines 256 and a plurality of work articles 450. The state machines 256 are configured to perform one or more timed actions on the work articles 450, and each state machine 256 has a defined state respectively during and between the timed actions, and a defined state transition from state to state. As mentioned above, the work articles 450 comprise workpieces 452 each having a workpiece configuration. The state machines 256 and work articles 450 are defined in the respective configuration files, as described above.

The step of receiving the software model 250 comprises receiving a software model 250 in which the state machines 256 comprise workers 258, workpiece stations 270, and automated ground vehicles (AGVs 420), as shown in the example manufacturing cell 400 of Figures 2-9. The workers 258 include one or more technicians 260 and/or one or more robotic devices 262 or other automated equipment. The timed actions performed by the workers 258 include operating on the workpieces 452 when the workpieces 452 (and pallets 442) are loaded onto the processing stations 276. Examples of timed actions performed by workers 258 include machining a workpiece 452 via a robotic device 262 in the machining subcell 402, cleaning a workpiece 452 via a technician 260 in the cleaning subcell 406, and inspecting a workpiece 452 via a robotic device 262 in the inspection subcell 404. As indicated above, the timed actions performed by the AGVs 420 include transporting the workpieces 452 (and pallets 442) between the workpiece stations 270, transferring the workpieces 452 (and pallets 442) onto and off of the workpiece stations 270, and other timed actions.

Step 502 also includes receiving, in the simulation manager 220, the production configuration 190 of workpieces 452. As mentioned above, the production configuration 190 is a list of all workpieces 452 (optionally supported on pallets 442) to be processed by the manufacturing cell 400 during a predetermined time period (e.g., a day, a shift). Each workpiece 452 in the production configuration 190 has one of the workpiece configurations defined in the software model 250. As mentioned above, the workpiece file is one of the configuration files that contains the workpiece configurations that define each workpiece 452 to be processed by the manufacturing cell 400. As also mentioned above, the production configuration 190 is entered, modified, and approved by a production controller 174. In addition, the production controller 174 generates, reviews, and approves of long-term build plans. The cell leader 176 may view, modify (e.g., bump workpieces 452 or pallets 442), and approve of the daily build plan, and send the approved daily build plan to the hardware interface module 210. As shown in Figure 10, the best seed (i.e., the workpiece order with the shortest completion time) from the uncertainty analysis becomes the long-term build plan 192, which may cover 1-3 weeks of production by the manufacturing cell 400.

The method additionally includes step 504 of simulating, via the simulation manager 220, the processing of the workpieces 452 arranged in a workpiece order. As illustrated in Figure 13, the simulation of the workpiece order includes creating, at initiation of the simulation, an instance (i.e., a software object) of the software model 250 and an instance of a simulation controller 206. As mentioned above, the simulation controller 206 has a pre-programmed set of rules for determining the priority or order in which the timed actions are performed on the workpieces 452 in the workpiece order. The simulation process further includes determining, via the simulation controller 206, the next timed action to be performed by the state machines 256, incrementing the simulation to the next timed action, and updating the software model 250 and the simulation controller 206 each time one of the state machines 256 performs a timed action, and recording the state transitions associated with the timed action. The steps of determining the next timed action, incrementing the simulation, and updating the software model 250 and the simulation controller 206, are repeated until all of the workpieces 452 in the workpiece order have been processed.

The method additionally includes step 506 of outputting a simulated completion time for processing the workpiece order, and a state transition log of the state transitions recorded for each state machine 256 during processing of the workpiece order. Advantageously, the simulation provides a cost-effective and timely method for accurately determining the processing capability of a manufacturing cell 400. In addition, the state transition logs from the simulation may be reviewed to identify worker behaviors that may be adjusted to increase worker efficiency. The simulation of the workpiece order also provides a more cost-effective means for determining the production efficiency of a given configuration of a manufacturing cell 400 than could be achieved by physically processing the workpieces 452. In this regard, the simulation allows designers to simulate many different configurations of the manufacturing cell 400 to find configurations that result in the shortest completion time and highest throughput for a given production configuration 190, and which ultimately reduces production cost.

Referring to Figures 13-14, the method may include incorporating a statistical model 230 into the simulation as a means for early termination of simulations that would otherwise have excessively long completion times. In this regard, the method may include accessing, via the simulation manager 220, a statistical model 230 of the manufacturing cell 400 for estimating the quantity of work (i.e., timed actions) remaining to be performed on the workpiece order at any given point in time during processing of the workpiece order by the manufacturing cell 400. The method includes receiving, from the statistical model 230, a best-case completion time 232 of the workpiece order, generated by a multiple linear regression that is fit to statistical model parameters of the workpiece order. The statistical model parameters include quantity of workpieces 452 in a workpiece order, the mean of the timed actions in the production configuration, and the standard deviation of the timed actions in the production configuration. As described above, Figure 14 is a graph of simulation time vs. work completed (timed actions) for the simulation of workpiece orders. The solid line (i.e., the upper-righthand end point of the line) represents the best-case completion time 232 of a statistical model 230.

As shown in Figure 13, the method includes continuously evaluating, after each update of the software model 250, the status of the simulation prior to simulating all of the workpieces 452 in the workpiece order. The process of continuously evaluating the status of the simulation comprises, adding the duration of the most recently completed simulated timed action to a running total of the duration of the simulated timed actions performed up to the most recent update of the software model 250, and determining, at that point in the simulation, a best-case interim time 234 of the statistical model 230. The best-case interim time 234 is calculated as a function of the best-case completion time 232 of the statistical model 230, and the sum of the duration of every timed action required to complete the workpiece order in the current simulation. The method may additionally include calculating the difference between the statistically-modeled best-case interim time 234 and the running total of the duration of the simulated timed actions. The method may also include terminating the simulation of the workpiece order if the difference is greater than 50 percent of the best-case interim time 234. Advantageously, by terminating simulations that result in excessively long completion times, a larger quantity of simulations can be performed in the same amount of time, and which improves the probability of finding the highest-throughput workpiece order.

Referring to Figure 15, the method may include performing a plurality of simulations on the same production configuration 190 of workpieces 452 as a means to find workpiece orders that result in short completion times. In this regard, the method includes receiving, in the batch analysis tool 290, batch analysis inputs, which include all of the simulation manager inputs. In addition, the batch analysis inputs may include the quantity of iterations (e.g., 100 iterations) of the workpiece order to simulate. After entry of the batch analysis inputs, the batch analysis process includes performing, via the batch analysis tool 290, the steps of creating a random seed number, and randomizing the workpiece order by arranging the workpieces 452 of the production configuration 190 into a different ordering than previously simulated using a random number generator initialized with the random seed number. Each one of the randomized workpiece orders is associated with a seed number. The batch analysis process further includes performing, using the simulation manager 220, a simulation of the randomized workpiece order. The method includes repeating the steps of creating a random seed number, randomizing the workpiece order, and performing a simulation of the randomized workpiece order until all of the iterations are complete. After completing the quantity of iterations entered at the initiation of the batch analysis, the method includes outputting a batch analysis list of the seed numbers and corresponding simulated completion time for each of the randomized workpiece orders. A user 170 may select the workpiece order with the shortest completion time as the workpiece order to submit to the manufacturing cell 400 for production.

Referring to Figure 16, the method may include performing an uncertainty analysis on a production configuration 190 as a means for evaluating the robustness of a simulation of a workpiece order. More specifically, the uncertainty analysis provides a means for estimating the impact of uncertainty in the duration of the timed actions on the completion time of a workpiece order. In this regard, the method includes receiving, in an uncertainty analysis tool 300, the above-mentioned batch analysis inputs. In addition, the uncertainty analysis receives at least two of the randomized workpiece orders, selected from the batch analysis list, and each of which has a simulated completion time that is shorter than the simulated completion time of the remaining randomized workpiece orders. The uncertainty analysis tool 300 also receives a quantity of iterations of the uncertainty analysis to perform on the at least two randomized workpiece orders selected from the batch analysis list, and a maximum simulation time for performing iterations of the uncertainty analysis on the randomized workpiece orders selected from the batch analysis list. The quantity of iterations and the maximum simulation time may be entered by a user. The uncertainty analysis tool 300 also receives a maximum variability of the timed actions of the state machines 256. As indicated above, the worker file defines the expected maximum variability in the amount of time required to perform each one of the timed actions defined for the workpieces 452.

Once the uncertainty analysis tool 300 has received all the inputs, the method includes performing an uncertainty analysis via the uncertainty analysis tool 300. The uncertainty analysis tool 300 is based on the premise that not every state machine 256 will behave in exactly the same way. For example, not every AGV 420 will move at exactly the same speed, and not every robotic device will take the same amount of time to perform the same type of timed action. The uncertainty analysis considers the above-mentioned maximum variabilities in the timed actions, and adjusts the value (e.g., the duration, the rate, etc.) of the timed action of the state machines 256 up to the expected maximum variability. The uncertainty analysis includes performing, using the simulation manager 220, a simulation of the workpiece order having the changed timed action. After simulating the workpiece order, the uncertainty analysis process includes updating the simulated completion time for the workpiece order as a result of the changed timed action. The uncertainty analysis process additionally includes repeating, for every workpiece order, the steps of changing the value of a timed action of at least one state machine 256, performing the simulation of the workpiece order, and updating the simulated completion time, until either completing the quantity of iterations of the uncertainty analysis, or reaching the maximum simulation time, whichever occurs first.

The uncertainty analysis process additionally includes saving a list of the updated simulated completion times of the workpiece order for each one of the changed timed actions, and determining the mean and the standard deviation of the updated simulated completion times of the workpiece order for each of the timed actions. The uncertainty analysis process may combine the mean and the standard deviation to create a composite score for each workpiece order. After generating the composite scores, the method includes identifying a plurality of top seeds and associated workpiece orders resulting from the uncertainty analysis. The top seeds are defined as the seeds for which the workpiece order has a lower composite score than 90 percent of all of the workpiece orders subjected to the uncertainty analysis (i.e., the top 10 percent of the workpiece orders subjected to the uncertainty analysis). The method additionally includes identifying, from among the top seeds, the best seed, which are described as the seed for which the workpiece order has the lowest composite score. The uncertainty analysis includes outputting an uncertainty analysis list, which contains the best seed, the top seeds, and the composite score associated with each seed, and also lists the workpiece order associated with each seed. The workpiece order associated with the top seed is transmitted to the cell leader 176 for review, and may be the workpiece ordered that is used to start processing of the actual workpieces 452 by the manufacturing cell 400.

Referring to Figure 17, the method may include using a controller analysis tool 310 to evaluate the effect of different simulation controllers 206 on the completion time for processing a workpiece order. The planning system 100 may include the above-mentioned controller library 314 which contains a plurality of different simulation controllers 206. As mentioned above, each simulation controller 206 includes a unique set of rules for determining the order in which timed actions are performed on the workpieces 452 in a workpiece order. The controller analysis tool 310 includes a controller analysis algorithm 312 that is configured to evaluate the different controllers by first performing the above-described batch analysis for simulating a plurality of workpiece orders of the production configuration 190, using one of the simulation controllers 206 previously unused in a simulation. The controller analysis further includes saving, for each workpiece order simulated via the batch analysis, the simulated completion time using the simulation controller 206, and the seed associated with each workpiece order. In addition, the controller analysis includes identifying or determining the seeds for which the workpiece order has a shorter simulated completion time than 90 percent of all of the workpiece orders simulated using the simulation controller 206. The controller analysis process also includes repeating, for each simulation controller 206 until all simulation controllers 206 have results (i.e., until all simulation controllers 206 have been used in a batch analysis), the steps of performing the batch analysis, saving the simulated completion time and associated seed, and determining the seeds for the workpiece order that has the shorter simulated completion time (e.g., shorter than 90 percent of the workpiece orders). The controller analysis process further includes performing, for each simulation controller 206, the above-described uncertainty analysis on each workpiece order that has the shorter simulated completion time (e.g., shorter than 90 percent of the workpiece orders), and outputting a list of the simulation controllers 206 and corresponding composite scores.

A controller analysis may typically be performed if there have been significant changes to the configuration of the manufacturing cell 400, such as changes to the physical locations of the workers 258 in the manufacturing cell 400. In addition, a controller analysis may be performed if there have been significant changes to any of the state machines 256, such as changes to the workers 258, workpiece stations 270, workpiece mounting fixtures 446, station frames 440, AGVs 420, and/or other automated equipment. A controller analysis may assist designers in making decisions on procuring new production equipment for a factory expansion, and may also assist in predicting the impact of adding new workpiece configurations for processing by an existing manufacturing cell 400.

In any one of the simulation and/or analysis examples disclosed herein, after identifying or generating a workpiece order that has an acceptable completion time, the method may include transmitting the workpiece order from the PUP core 102 to the manufacturing cell 400, and commanding the manufacturing cell 400 to start production of the workpiece order. For example, the cell leader 176 may use the web app 194 to transmit a workpiece order to the hardware interface module 210 to begin production. At that point, operators (e.g., forklift operators) use the web app 194 to receive instructions for loading and unloading workpieces 452 (pallets 442) at the feed stations 272, including the order in which to load each workpiece 452 (or pallet 442). The PUP core 102 controls the flow of workpieces 452 through the manufacturing cell 400. The cell leader 176 may use the web app 194 to monitor and potentially override control decisions made by the PUP core 102.

Referring to Figures 18-19, the method may include continuously monitoring the operation of the manufacturing cell 400 during production of a workpiece order. Figure 18 shows a discrepancy hunter module 320, and Figure 19 shows an error prediction module 322, which are each submodules of the health monitor module 318. As mentioned above, the discrepancy hunter module 320 requests and receives real-time performance data from the hardware interface module 210 regarding the operation of the manufacturing cell 400 during processing of the workpiece order. For example, the discrepancy hunter module 320 which may receive real-time performance data for physical components such as the AGVs 420, the robotic devices 262, and other automated equipment of the manufacturing cell 400. The discrepancy hunter module 320 compares the real-time operating performance of the manufacturing cell 400 to predicted performance based on a simulation of the workpiece order, and the tax discrepancies between the real-time performance and the predicted performance.

The discrepancy hunter module 320 proposes changes to one or more of the modeled parameters of the software model 250 to better reflect the real-time performance of the manufacturing cell 400. For example, if the real-time performance for cleaning a workpiece 452 is 159 seconds, and the predicted performance is 300 seconds, the discrepancy hunter module 320 causes the cell lead interface 126 to display such information in a model update window, and which includes an identification of the workpiece 452, and a listing of the current value (e.g., 159 seconds) and a proposed updated value (e.g., 300 seconds) for the cleaning operation. The model update window additionally includes a selection feature (e.g., a radio button) allowing the cell leader 176 to either reject or accept the proposed update of the modeled parameter.

Referring to Figure 19, the method may include detecting errors and/or failures of the manufacturing cell 400 via the error prediction module 322. In addition, the method may include detecting trends in the modeled parameters of the state machines 256 based on discrepancies between the real-time performance and the simulated and/or historical performance, and which may be an indication of a potential upcoming failure in the manufacturing cell 400. For example, a continuing increase in the amount of time required for a robotic device 262 to perform the same type of machining operation on a series of workpieces 452 may be indicative of a worn or damaged end effector 266. In this regard, the method may include generating alerts of potential health issues of the manufacturing cell 400. Such alerts are displayed in the error message window 144 on one or more of the above-mentioned user interfaces 120.

Additional modifications and improvements of the present disclosure may be apparent to those of ordinary skill in the art. Thus, the particular combination of parts described and illustrated herein is intended to represent only certain examples of the present disclosure and is not intended to serve as limitations of alternative examples or devices within the spirit and scope of the disclosure.

Further, the disclosure comprises examples according to the following clauses:
Clause 1. A planning system 100 for simulating the processing of workpieces 452 by a manufacturing cell 400, the planning system 100 comprising: a production utilization planner (PUP) core 102 having a simulation and analysis module 104 having a processor 106 and a memory 108 storing instructions that, when executed by the processor 106, cause the simulation and analysis module 104 to perform as: a simulation manager 220 configured to receive simulation manager inputs, comprising: a software model 250 of the manufacturing cell 400, having model components 252 including: a plurality of state machines 256 and a plurality of work articles 450; the state machines 256 are configured to perform one or more timed actions on the work articles 450, and each state machine 256 has a defined state respectively during and between the timed actions, and a defined state transition from state to state; the work articles 450 comprise workpieces 452, each having a workpiece configuration; a production configuration 190 comprising a list of workpieces 452 to be processed by the manufacturing cell 400, each having one of the workpiece configurations defined in the software model 250; the simulation manager 220 is configured to perform the following: simulate the processing, via the state machines 256, of the workpieces 452 arranged in a workpiece order, by performing the following steps: creating, at initiation of the simulation, an instance of the software model 250 and an instance of a simulation controller 206, the simulation controller 206 having a pre-programmed set of rules for determining the order in which the timed actions are performed on the workpieces 452 in the workpiece order; determining, via the simulation controller 206, a next timed action to be performed by the state machines 256; incrementing the simulation to the next timed action; updating the software model 250 and the simulation controller 206 each time one of the state machines 256 performs a timed action, and recording the state transitions associated with the timed action; repeating the steps of determining the next timed action, incrementing the simulation, and updating the software model 250 and the simulation controller 206, until all of the workpieces 452 in the workpiece order have been processed; output: a simulated completion time for processing the workpiece order; and a state transition log of the state transitions recorded for each state machine 256 during processing of the workpiece order.
Clause 2. The planning system 100 of clause 1, wherein the PUP core 102 further comprises: a batch analysis tool 290, configured to receive batch analysis inputs, including: the simulation manager inputs; a quantity of iterations of the workpiece order to simulate; the batch analysis tool 290 is configured to perform a batch analysis by performing the following: creating a random seed number; randomizing the workpiece order by arranging the workpieces 452 of the production configuration 190 into a different ordering than previously simulated using a random number generator initialized with the random seed number, and associating the randomized workpiece order with the seed number; performing, using the simulation manager 220, a simulation of the randomized workpiece order; repeating the steps of creating a random seed number, randomizing the workpiece order, and performing a simulation of the randomized workpiece order until all of the quantity of iterations have been completed; and outputting a batch analysis list of the seed numbers and corresponding simulated completion time for each of the randomized workpiece orders.
Clause 3. The planning system 100 of any of clauses 1 or 2, wherein the PUP core 102 further comprises: an uncertainty analysis tool 300 configured to receive: the batch analysis inputs; at least two of the randomized workpiece orders, selected from the batch analysis list, and having a simulated completion time that is shorter than the simulated completion time of the remaining ones of the randomized workpiece orders; a quantity of iterations of the uncertainty analysis to perform on the at least two randomized workpiece orders selected from the batch analysis list; a maximum simulation time for performing iterations of the uncertainty analysis on the at least two randomized workpiece orders selected from the batch analysis list; a maximum variability of at least one timed action of at least one of the state machines 256; the uncertainty analysis tool 300 configured to: perform, on the at least two randomized workpiece orders selected from the batch analysis list, an uncertainty analysis by performing the following: changing the value of at least one timed action of at least one of the state machines 256 up to its maximum variability; performing, using the simulation manager 220, a simulation of the workpiece order having the changed timed action; updating the simulated completion time for the workpiece order as a result of the changed timed action; repeating, for every workpiece order, the steps of changing the value of at least one timed action of at least one state machine 256, performing the simulation of the workpiece order, and updating the simulated completion time until either completing the quantity of iterations of the uncertainty analysis, or reaching the maximum simulation time, whichever occurs first; saving a list of the updated simulated completion times of the workpiece order for each one of the changed timed actions; determining a mean and a standard deviation of the updated simulated completion times of the workpiece order for each of the timed actions, and combining the mean and the standard deviation to create a composite score for the workpiece order; identify a plurality of top seeds as the seeds for which the workpiece order has a lower composite score than 90 percent of all of the workpiece orders subjected to the uncertainty analysis; identify, from among the top seeds, a best seed for which the workpiece order has the lowest composite score; and output an uncertainty analysis list containing the best seed, the top seeds, and the associated composite scores.
Clause 4. The planning system 100 of any of clauses 1 or 2 or 3, wherein the PUP core 102 further comprises: a controller analysis tool 310, communicatively coupled to a controller library 314 containing a plurality of simulation controllers 206 each having a different set of rules for determining the order in which the timed actions are performed on the workpieces 452 in the production configuration 190; the controller analysis tool 310 configured to perform a controller analysis to evaluate the effect of each one of the simulation controllers 206 on the completion time for processing the production configuration 190 by the manufacturing cell 400, by performing the following: performing a batch analysis for simulating a plurality of workpiece orders of the production configuration 190, using one of the simulation controllers 206 previously unused in a simulation; saving, for each workpiece order simulated via the batch analysis, the simulated completion time using the simulation controller 206, and the seed associated with each workpiece order; determining, for the simulation controller 206, the seeds for which the workpiece order has a shorter simulated completion time than 90 percent of all of the workpiece orders simulated using the simulation controller 206; repeating, for each simulation controller 206 until all simulation controllers 206 have results, the steps of performing the batch analysis, saving the simulated completion time and associated seed, and determining the seeds for the workpiece order that has the shorter simulated completion time; performing, for each simulation controller 206, the uncertainty analysis on each workpiece order that has the shorter simulated completion time; and outputting a list of the simulation controllers 206 and corresponding composite scores, to facilitate identifying the simulation controller 206 that results in the shortest simulated completion time for the production configuration 190.
Clause 5. The planning system 100 of any of clauses 1 or 2 or 3 or 4, wherein the PUP core 102 further comprises: a hardware interface module 210 communicatively coupling the PUP core 102 to the manufacturing cell 400; and the hardware interface module 210 configured to transmit the workpiece order from the PUP core 102 to the manufacturing cell 400, and initiate production of the workpiece order upon user command.
Clause 6. The planning system 100 of any of clauses 1 or 2 or 3 or 4 or 5, wherein the PUP core 102 further comprises: a health monitor module 318, communicatively coupled to the manufacturing cell 400 via the hardware interface module 210 and configured to: monitor real-time performance of the manufacturing cell 400 during processing of the workpiece order; compare the real-time performance of the manufacturing cell 400 to predicted performance based on the simulation of the workpiece order in the software model 250; and detect at least one of: errors and/or failures of the manufacturing cell 400; and discrepancies between the real-time performance of the manufacturing cell 400 and the predicted performance based on the simulation.
Clause 7. The planning system 100 of any of clauses 1 or 2 or 3 or 4 or 5 or 6, wherein the health monitor module 318 is configured to: detect trends in one or more modeled parameters of the state machines 256 in the manufacturing cell 400 based on the discrepancies between the real-time performance and the simulated performance; and propose changes to one or more of the modeled parameters of the software model 250 based on the trend, to reflect the real-time performance of the manufacturing cell 400.
Clause 8. The planning system 100 of any of clauses 1 or 2 or 3 or 4 or 5 or 6 or 7, further comprising: a statistical model 230 for estimating the quantity of work remaining to be performed on the workpiece order at any given point in time during processing of the workpiece order by the manufacturing cell 400, the statistical model 230 including: a best-case completion time 232 of the workpiece order, generated by a multiple linear regression that is fit to statistical model 230 parameters of the workpiece order, the statistical model 230 parameters at least including: quantity of workpieces 452 in the workpiece order, the mean of the timed actions in the production configuration 190, and the standard deviation of the timed actions in the production configuration 190; the simulation manager 220 is configured to continuously evaluate the status of the simulation prior to simulating all of the workpieces 452 in the workpiece order, by performing the following after each update of the software model 250: adding the duration of the most recently completed simulated timed action to a running total of the duration of the simulated timed actions performed up to the most recent update of the software model 250; determining, at that point in the simulation, a statistically-modeled best-case interim time 234, calculated as a function of the statistically-modeled best-case completion time 232 and the sum of the duration of every timed action required to complete the workpiece order; calculating the difference between the statistically-modeled best-case interim time 234 to the running total of the duration of the simulated timed actions; and terminating the simulation of the workpiece order if the difference is greater than 50 percent of the best-case interim time 234.
Clause 9. The planning system 100 of any of clauses 1 or 2 or 3 or 4 or 5 or 6 or 7 or 8, further comprising: at least one user interface 120, communicatively coupled to the PUP core 102, and configured to perform at least one of the following: facilitate user entry of a least one of simulation parameters 204, worker schedules, and availability dates and completion dates of the workpieces 452 in the production configuration 190; display upcoming tasks to be performed by workers 258, including at least technicians 260 or robotic device 262; generate alerts of potential health issues of the manufacturing cell 400; display proposed changes to one or more modelled parameters of the software model 250 based on discrepancies with real-time performance of the manufacturing cell 400; and facilitate user adjustment of one of more of the modelled parameters.
Clause 10. A planning system 100 for simulating the processing of workpieces 452 by a manufacturing cell 400, the planning system 100 comprising: a production utilization planner (PUP) core 102 having a simulation and analysis module 104 having a processor 106 and a memory 108, the memory 108 storing instructions that, when executed by the processor 106, cause the simulation and analysis module 104 to perform as: a simulation manager 220 configured to receive simulation manager inputs, comprising: a software model 250 of the manufacturing cell 400, having model components 252 including: a plurality of state machines 256 and a plurality of work articles 450; the state machines 256 comprising workers 258, workpiece stations 270, and automated ground vehicles 420 (AGVs), each state machine 256 is configured to perform one or more timed actions on the work articles 450, and each state machine 256 has a defined state respectively during and between the timed actions, and a defined state transition from state to state; the work articles 450 comprising workpieces 452 and pallets 442 for supporting the workpieces 452, each workpiece 452 having a workpiece configuration; the workers 258 comprising at least one of a technician 260 and a robotic device 262, the timed actions performed by the workers 258 include operating on the workpieces 452 when the pallets 442 are loaded onto the workpiece stations 270; the timed actions performed by the AGVs 420 include transporting the pallets 442 between the workpiece stations 270; a production configuration 190 comprising a list of workpieces 452 to be processed by the manufacturing cell 400, each having one of the workpiece configurations defined in the software model 250; the simulation manager 220 is configured to perform the following: simulate the processing, via the state machines 256, of the workpieces 452 arranged in a workpiece order, by performing the following steps: creating, at initiation of the simulation, an instance of the software model 250 and an instance of a simulation controller 206, the simulation controller 206 having a pre-programmed set of rules for determining the order in which the timed actions are performed on the workpieces 452 in the workpiece order; determining, via the simulation controller 206, a next timed action to be performed by the state machines 256; incrementing the simulation to the next timed action; updating the software model 250 and the simulation controller 206 each time one of the state machines 256 performs a timed action, and recording the state transitions associated with the timed action; repeating the steps of determining the next timed action, incrementing the simulation, and updating the software model 250 and the simulation controller 206, until all of the workpieces 452 in the workpiece order have been processed; output: a simulated completion time for processing the workpiece order; and a state transition log of the state transitions recorded for each state machine 256 during processing of the workpiece order.
Clause 11. A method 500 of simulating the processing of workpieces 452 by a manufacturing cell 400, the method 500 comprising: receiving, in a simulation manager 220 of a production utilization planner (PUP) core 102, simulation manager inputs including: a software model 250 of the manufacturing cell 400, the software model 250 having model components 252 including a plurality of state machines 256 and a plurality of work articles 450, the state machines 256 are configured to perform one or more timed actions on the work articles 450, and each state machine 256 has a defined state respectively during and between the timed actions, and a defined state transition from state to state, the work articles 450 comprise workpieces 452 each having a workpiece configuration; a production configuration 190 comprising a list of workpieces 452 to be processed by the manufacturing cell 400, each having one of the workpiece configurations defined in the software model 250; simulating, via the simulation manager 220, the processing of the workpieces 452 arranged in a workpiece order, by performing the following steps: creating, at initiation of the simulation, an instance of the software model 250 and an instance of a simulation controller 206, the simulation controller 206 having a pre-programmed set of rules for determining the order in which the timed actions are performed on the workpieces 452 in the workpiece order; determining, via the simulation controller 206, a next timed action to be performed by the state machines 256; incrementing the simulation to the next timed action; updating the software model 250 and the simulation controller 206 each time one of the state machines 256 performs a timed action, and recording the state transitions associated with the timed action; repeating the steps of determining the next timed action, incrementing the simulation, and updating the software model 250 and the simulation controller 206, until all of the workpieces 452 in the workpiece order have been processed; and outputting a simulated completion time for processing the workpiece order, and a state transition log of the state transitions recorded for each state machine 256 during processing of the workpiece order.
Clause 12. The method 500 of clause 11, wherein the step of receiving the software model 250 includes: receiving the software model 250 in which the state machines 256 comprise workers 258, workpiece stations 270, and automated ground vehicles 420 (AGVs); the workers 258 comprise at least one of a technician 260 and a robotic device 262; the timed actions performed by the workers 258 include operating on the workpieces 452 when the pallets 442 are loaded onto the workpiece stations 270 that are within reach of the workers 258; and the timed actions performed by the AGVs 420 include transporting the workpieces 452 between the workpiece stations 270.
Clause 13. The method 500 of any of clauses 11 or 12, further comprising: receiving, in a batch analysis tool 290, batch analysis inputs including: the simulation manager inputs; a quantity of iterations of the workpiece order to simulate; performing, via the batch analysis tool 290, the following steps: creating a random seed number; randomizing the workpiece order by arranging the workpieces 452 of the production configuration 190 into a different ordering than previously simulated using a random number generator initialized with the random seed number, and associating the randomized workpiece order with the seed number; performing, using the simulation manager 220, a simulation of the randomized workpiece order; repeating the steps of creating a random seed number, randomizing the workpiece order, and performing a simulation of the randomized workpiece order until all of the iterations are complete; and outputting a batch analysis list of the seed numbers and corresponding simulated completion time for each of the randomized workpiece orders.
Clause 14. The method 500 of any of clauses 11 or 12 or 13, further comprising: receiving, in an uncertainty analysis tool 300: the batch analysis inputs; at least two of the randomized workpiece orders, selected from the batch analysis list, and having a simulated completion time that is shorter than the simulated completion time of the remaining ones of the randomized workpiece orders; a quantity of iterations of the uncertainty analysis to perform on the at least two randomized workpiece orders selected from the batch analysis list; a maximum simulation time for performing iterations of the uncertainty analysis on the at least two randomized pallet 442 orders selected from the batch analysis list; a maximum variability of at least one timed action of at least one of the state machines 256; performing, via the uncertainty analysis tool 300, an uncertainty analysis by: sequentially performing, on the at least two randomized workpiece orders selected from the batch analysis list, the following: changing the value of at least one timed action of at least one of the state machines 256 up to its maximum variability; performing, using the simulation manager 220, a simulation of the workpiece order having the changed timed action; updating the simulated completion time for the workpiece order as a result of the changed timed action; repeating, for every workpiece order, the steps of changing the value of at least one timed action of at least one state machine 256, performing the simulation of the workpiece order, and updating simulated completion time until either completing the quantity of iterations of the uncertainty analysis, or reaching the maximum simulation time, whichever occurs first; saving a list of the updated simulated completion times of the workpiece order for each one of the changed timed actions; determining a mean and a standard deviation of the updated simulated completion times of the workpiece order for each of the timed actions, and combining the mean and the standard deviation to create a composite score for the workpiece order; identifying a plurality of top seeds as the seeds for which the workpiece order has a lower composite score than 90 percent of all of the workpiece orders subjected to the uncertainty analysis; identifying, from among the top seeds, a best seed for which the workpiece order has the lowest composite score; and outputting an uncertainty analysis list containing the best seed, the top seeds, and the associated composite scores.
Clause 15. The method 500 of any of clauses 11 or 12 or 13 or 14, further comprising: evaluating, using a controller analysis tool 310, the effect of each one of the simulation controllers 206 on the completion time for processing the production configuration 190 by the manufacturing cell 400, each one of the simulation controllers 206 having a different set of rules for determining the order in which the timed actions are performed on the workpieces 452 in the production configuration 190, the step of evaluating including: performing a batch analysis for simulating a plurality of workpiece orders of the production configuration 190, using one of the simulation controllers 206 previously unused in a simulation; saving, for each workpiece order simulated via the batch analysis, the simulated completion time using the simulation controller 206, and the seed associated with each workpiece order; determining, for the simulation controller 206, the seeds for which the workpiece order has a shorter simulated completion time than 90 percent of all of the workpiece orders simulated using the simulation controller 206; repeating, for each simulation controller 206 until all simulation controllers 206 have results, the steps of performing the batch analysis, saving the simulated completion time and associated seed, and determining the seeds for the workpiece order that has the shorter simulated completion time; performing, for each simulation controller 206, the uncertainty analysis on each workpiece order that has the shorter simulated completion time; and outputting a list of the simulation controllers 206 and corresponding composite scores, to facilitate identifying the simulation controller 206 that results in the shortest simulated completion time for the production configuration 190.
Clause 16. The method 500 of any of clauses 11 or 12 or 13 or 14 or 15, further comprising: transmitting, using a hardware interface module 210, the workpiece order from the PUP core 102 to the manufacturing cell 400; and commanding, via the hardware interface module 210, production of the workpiece order by the manufacturing cell 400.
Clause 17. The method 500 of any of clauses 11 or 12 or 13 or 14 or 15 or 16, further comprising: monitoring, using a health monitor module 318 communicatively coupled to the manufacturing cell 400 via the hardware interface module 210, real-time performance of the manufacturing cell 400 during processing of the workpiece order; comparing the real-time performance of the manufacturing cell 400 to predicted performance based on the simulation of the workpiece order in the software model 250; and detecting at least one of: errors and/or failures of the manufacturing cell 400; and discrepancies between the real-time performance of the manufacturing cell 400 and the predicted performance based on the simulation.
Clause 18. The method 500 of any of clauses 11 or 12 or 13 or 14 or 15 or 16 or 17, further comprising: detecting trends in one or more modeled parameters of the state machines 256 in the manufacturing cell 400 based on the discrepancies between the real-time performance and the simulated performance; and proposing changes to one or more of the modeled parameters of the software model 250 based on the trend, to reflect the real-time performance of the manufacturing cell 400.
Clause 19. The method 500 of any of clauses 11 or 12 or 13 or 14 or 15 or 16 or 17 or 18, further comprising: accessing, via the simulation manager 220, a statistical model 230 of the manufacturing cell 400 for estimating the quantity of work remaining to be performed on the workpiece order at any given point in time during processing of the workpiece order by the manufacturing cell 400; receiving, from the statistical model 230, a best-case completion time 232 of the workpiece order, generated by a multiple linear regression that is fit to statistical model 230 parameters of the workpiece order, the statistical model 230 parameters at least including: quantity of workpieces 452 in the workpiece order, the mean of the timed actions in the production configuration 190, and the standard deviation of the timed actions in the production configuration 190; continuously evaluating, using the simulation manager 220, the status of the simulation prior to simulating all of the workpieces 452 in the workpiece order, by sequentially performing the following after each update of the software model 250: adding the duration of the most recently completed simulated timed action to a running total of the duration of the simulated timed actions performed up to the most recent update of the software model 250; determining, at that point in the simulation, a statistically-modeled best-case interim time 234, calculated as a function of the statistically-modeled best-case completion time 232 and the sum of the duration of every timed action required to complete the workpiece order; calculating the difference between the statistically-modeled best-case interim time 234 to the running total of the duration of the simulated timed actions; and terminating the simulation of the workpiece order if the difference is greater than 50 percent of the best-case interim time 234.
Clause 20. The method 500 of any of clauses 11 or 12 or 13 or 14 or 15 or 16 or 17 or 18 or 19, further comprising: performing, via a user interface 120 communicatively coupled to the PUP core 102, at least one of the following: entry, by a user 170, of a least one of simulation parameters 204, worker schedules, and availability dates and completion dates of the workpieces 452 in the production configuration 190; displaying upcoming tasks to be performed by workers 258, including at least technicians 260 or robotic device 262; generating alerts of potential health issues of the manufacturing cell 400; displaying proposed changes to one of more modeled parameters of the software model 250 based on discrepancies with real-time performance of the manufacturing cell 400; and adjustment, by a user 170, of one of more of the modeled parameters.

## Claims

1. A planning system (100) for simulating the processing of workpieces (452) by a manufacturing cell (400), the planning system (100) comprising:
a production utilization planner (PUP) core (102) having a simulation and analysis module (104) having a processor (106) and a memory (108) storing instructions that, when executed by the processor (106), cause the simulation and analysis module (104) to perform as:
a simulation manager (220) configured to receive simulation manager inputs, comprising:
a software model (250) of the manufacturing cell (400), having model components (252) including:
a plurality of state machines (256) and a plurality of work articles (450);
the state machines (256) are configured to perform one or more timed actions on the work articles (450), and each state machine (256) has a defined state respectively during and between the timed actions, and a defined state transition from state to state;
the work articles (450) comprise workpieces (452), each having a workpiece configuration;
a production configuration (190) comprising a list of workpieces (452) to be processed by the manufacturing cell (400), each having one of the workpiece configurations defined in the software model (250);
the simulation manager (220) is configured to perform the following:
simulate the processing, via the state machines (256), of the workpieces (452) arranged in a workpiece order, by performing the following steps:
creating, at initiation of the simulation, an instance of the software model (250) and an instance of a simulation controller (206), the simulation controller (206) having a pre-programmed set of rules for determining the order in which the timed actions are performed on the workpieces (452) in the workpiece order;
determining, via the simulation controller (206), a next timed action to be performed by the state machines (256);
incrementing the simulation to the next timed action;
updating the software model (250) and the simulation controller (206) each time one of the state machines (256) performs a timed action, and recording the state transitions associated with the timed action;
repeating the steps of determining the next timed action, incrementing the simulation, and updating the software model (250) and the simulation controller (206), until all of the workpieces (452) in the workpiece order have been processed;
output:
a simulated completion time for processing the workpiece order; and
a state transition log of the state transitions recorded for each state machine (256) during processing of the workpiece order.

2. The planning system (100) of Claim 1, wherein the PUP core (102) further comprises:
a batch analysis tool (290), configured to receive batch analysis inputs, including:
the simulation manager inputs;
a quantity of iterations of the workpiece order to simulate;
the batch analysis tool (290) is configured to perform a batch analysis by performing the following:
creating a random seed number;
randomizing the workpiece order by arranging the workpieces (452) of the production configuration (190) into a different ordering than previously simulated using a random number generator initialized with the random seed number, and associating the randomized workpiece order with the seed number;
performing, using the simulation manager (220), a simulation of the randomized workpiece order;
repeating the steps of creating a random seed number, randomizing the workpiece order, and performing a simulation of the randomized workpiece order until all of the quantity of iterations have been completed; and
outputting a batch analysis list of the seed numbers and corresponding simulated completion time for each of the randomized workpiece orders.

3. The planning system (100) of Claim 2, wherein the PUP core (102) further comprises:
an uncertainty analysis tool (300) configured to receive:
the batch analysis inputs;
at least two of the randomized workpiece orders, selected from the batch analysis list, and having a simulated completion time that is shorter than the simulated completion time of the remaining ones of the randomized workpiece orders;
a quantity of iterations of the uncertainty analysis to perform on the at least two randomized workpiece orders selected from the batch analysis list;
a maximum simulation time for performing iterations of the uncertainty analysis on the at least two randomized workpiece orders selected from the batch analysis list;
a maximum variability of at least one timed action of at least one of the state machines (256);
the uncertainty analysis tool (300) configured to:
perform, on the at least two randomized workpiece orders selected from the batch analysis list, an uncertainty analysis by performing the following:
changing the value of at least one timed action of at least one of the state machines (256) up to its maximum variability;
performing, using the simulation manager (220), a simulation of the workpiece order having the changed timed action;
updating the simulated completion time for the workpiece order as a result of the changed timed action;
repeating, for every workpiece order, the steps of changing the value of at least one timed action of at least one state machine (256), performing the simulation of the workpiece order, and updating the simulated completion time until either completing the quantity of iterations of the uncertainty analysis, or reaching the maximum simulation time, whichever occurs first;
saving a list of the updated simulated completion times of the workpiece order for each one of the changed timed actions;
determining a mean and a standard deviation of the updated simulated completion times of the workpiece order for each of the timed actions, and combining the mean and the standard deviation to create a composite score for the workpiece order;
identify a plurality of top seeds as the seeds for which the workpiece order has a lower composite score than 90 percent of all of the workpiece orders subjected to the uncertainty analysis;
identify, from among the top seeds, a best seed for which the workpiece order has the lowest composite score; and
output an uncertainty analysis list containing the best seed, the top seeds, and the associated composite scores.

4. The planning system (100) of Claim 3, wherein the PUP core (102) further comprises:
a controller analysis tool (310), communicatively coupled to a controller library (314) containing a plurality of simulation controllers (206) each having a different set of rules for determining the order in which the timed actions are performed on the workpieces (452) in the production configuration (190);
the controller analysis tool (310) configured to perform a controller analysis to evaluate the effect of each one of the simulation controllers (206) on the completion time for processing the production configuration (190) by the manufacturing cell (400), by performing the following:
performing a batch analysis for simulating a plurality of workpiece orders of the production configuration (190), using one of the simulation controllers (206) previously unused in a simulation;
saving, for each workpiece order simulated via the batch analysis, the simulated completion time using the simulation controller (206), and the seed associated with each workpiece order;
determining, for the simulation controller (206), the seeds for which the workpiece order has a shorter simulated completion time than 90 percent of all of the workpiece orders simulated using the simulation controller (206);
repeating, for each simulation controller (206) until all simulation controllers (206) have results, the steps of performing the batch analysis, saving the simulated completion time and associated seed, and determining the seeds for the workpiece order that has the shorter simulated completion time;
performing, for each simulation controller (206), the uncertainty analysis on each workpiece order that has the shorter simulated completion time; and
outputting a list of the simulation controllers (206) and corresponding composite scores, to facilitate identifying the simulation controller (206) that results in the shortest simulated completion time for the production configuration (190).

5. The planning system (100) of any one of Claims 1-4, wherein the PUP core (102) further comprises:
a hardware interface module (210) communicatively coupling the PUP core (102) to the manufacturing cell (400); and
the hardware interface module (210) configured to transmit the workpiece order from the PUP core (102) to the manufacturing cell (400), and initiate production of the workpiece order upon user command.

6. The planning system (100) of Claim 5, wherein the PUP core (102) further comprises:
a health monitor module (318), communicatively coupled to the manufacturing cell (400) via the hardware interface module (210) and configured to:
monitor real-time performance of the manufacturing cell (400) during processing of the workpiece order;
compare the real-time performance of the manufacturing cell (400) to predicted performance based on the simulation of the workpiece order in the software model (250); and
detect at least one of:
errors and/or failures of the manufacturing cell (400); and
discrepancies between the real-time performance of the manufacturing cell (400) and the predicted performance based on the simulation.

7. The planning system (100) of Claim 6, wherein the health monitor module (318) is configured to:
detect trends in one or more modeled parameters of the state machines (256) in the manufacturing cell (400) based on the discrepancies between the real-time performance and the simulated performance; and
propose changes to one or more of the modeled parameters of the software model (250) based on the trend, to reflect the real-time performance of the manufacturing cell (400).

8. The planning system (100) of any one of Claims 1-7, further comprising:
a statistical model (230) for estimating the quantity of work remaining to be performed on the workpiece order at any given point in time during processing of the workpiece order by the manufacturing cell (400), the statistical model (230) including:
a best-case completion time (232) of the workpiece order, generated by a multiple linear regression that is fit to statistical model (230) parameters of the workpiece order, the statistical model (230) parameters at least including: quantity of workpieces (452) in the workpiece order, the mean of the timed actions in the production configuration (190), and the standard deviation of the timed actions in the production configuration (190);
the simulation manager (220) is configured to continuously evaluate the status of the simulation prior to simulating all of the workpieces (452) in the workpiece order, by performing the following after each update of the software model (250):
adding the duration of the most recently completed simulated timed action to a running total of the duration of the simulated timed actions performed up to the most recent update of the software model (250);
determining, at that point in the simulation, a statistically-modeled best-case interim time (234), calculated as a function of the statistically-modeled best-case completion time (232) and the sum of the duration of every timed action required to complete the workpiece order;
calculating the difference between the statistically-modeled best-case interim time (234) to the running total of the duration of the simulated timed actions; and
terminating the simulation of the workpiece order if the difference is greater than 50 percent of the best-case interim time (234).

9. The planning system (100) of any one of Claims 1-8, further comprising:
at least one user interface (120), communicatively coupled to the PUP core (102), and configured to perform at least one of the following:
facilitate user entry of a least one of simulation parameters (204), worker schedules, and availability dates and completion dates of the workpieces (452) in the production configuration (190);
display upcoming tasks to be performed by workers (258), including at least technicians (260) or robotic device (262);
generate alerts of potential health issues of the manufacturing cell (400);
display proposed changes to one or more modelled parameters of the software model (250) based on discrepancies with real-time performance of the manufacturing cell (400); and
facilitate user adjustment of one of more of the modelled parameters.

10. A method (500) of simulating the processing of workpieces (452) by a manufacturing cell (400), the method (500) comprising:
receiving, in a simulation manager (220) of a production utilization planner (PUP) core (102), simulation manager inputs including:
a software model (250) of the manufacturing cell (400), the software model (250) having model components (252) including a plurality of state machines (256) and a plurality of work articles (450), the state machines (256) are configured to perform one or more timed actions on the work articles (450), and each state machine (256) has a defined state respectively during and between the timed actions, and a defined state transition from state to state, the work articles (450) comprise workpieces (452) each having a workpiece configuration;
a production configuration (190) comprising a list of workpieces (452) to be processed by the manufacturing cell (400), each having one of the workpiece configurations defined in the software model (250);
simulating, via the simulation manager (220), the processing of the workpieces (452) arranged in a workpiece order, by performing the following steps:
creating, at initiation of the simulation, an instance of the software model (250) and an instance of a simulation controller (206), the simulation controller (206) having a pre-programmed set of rules for determining the order in which the timed actions are performed on the workpieces (452) in the workpiece order;
determining, via the simulation controller (206), a next timed action to be performed by the state machines (256);
incrementing the simulation to the next timed action;
updating the software model (250) and the simulation controller (206) each time one of the state machines (256) performs a timed action, and recording the state transitions associated with the timed action;
repeating the steps of determining the next timed action, incrementing the simulation, and updating the software model (250) and the simulation controller (206), until all of the workpieces (452) in the workpiece order have been processed; and
outputting a simulated completion time for processing the workpiece order, and a state transition log of the state transitions recorded for each state machine (256) during processing of the workpiece order.

11. The method (500) of Claim 10, wherein the step of receiving the software model (250) includes:
receiving the software model (250) in which the state machines (256) comprise workers (258), workpiece stations (270), and automated ground vehicles (420) (AGVs);
the workers (258) comprise at least one of a technician (260) and a robotic device (262);
the timed actions performed by the workers (258) include operating on the workpieces (452) when the pallets (442) are loaded onto the workpiece stations (270) that are within reach of the workers (258); and
the timed actions performed by the AGVs (420) include transporting the workpieces (452) between the workpiece stations (270).

12. The method (500) of Claim 10 or 11, further comprising:
receiving, in a batch analysis tool (290), batch analysis inputs including:
the simulation manager inputs;
a quantity of iterations of the workpiece order to simulate;
performing, via the batch analysis tool (290), the following steps:
creating a random seed number;
randomizing the workpiece order by arranging the workpieces (452) of the production configuration (190) into a different ordering than previously simulated using a random number generator initialized with the random seed number, and associating the randomized workpiece order with the seed number;
performing, using the simulation manager (220), a simulation of the randomized workpiece order;
repeating the steps of creating a random seed number, randomizing the workpiece order, and performing a simulation of the randomized workpiece order until all of the iterations are complete; and
outputting a batch analysis list of the seed numbers and corresponding simulated completion time for each of the randomized workpiece orders.

13. The method (500) of Claim 12, further comprising:
receiving, in an uncertainty analysis tool (300):
the batch analysis inputs;
at least two of the randomized workpiece orders, selected from the batch analysis list, and having a simulated completion time that is shorter than the simulated completion time of the remaining ones of the randomized workpiece orders;
a quantity of iterations of the uncertainty analysis to perform on the at least two randomized workpiece orders selected from the batch analysis list;
a maximum simulation time for performing iterations of the uncertainty analysis on the at least two randomized pallet (442) orders selected from the batch analysis list;
a maximum variability of at least one timed action of at least one of the state machines (256);
performing, via the uncertainty analysis tool (300), an uncertainty analysis by:
sequentially performing, on the at least two randomized workpiece orders selected from the batch analysis list, the following:
changing the value of at least one timed action of at least one of the state machines (256) up to its maximum variability;
performing, using the simulation manager (220), a simulation of the workpiece order having the changed timed action;
updating the simulated completion time for the workpiece order as a result of the changed timed action;
repeating, for every workpiece order, the steps of changing the value of at least one timed action of at least one state machine (256), performing the simulation of the workpiece order, and updating simulated completion time until either completing the quantity of iterations of the uncertainty analysis, or reaching the maximum simulation time, whichever occurs first;
saving a list of the updated simulated completion times of the workpiece order for each one of the changed timed actions;
determining a mean and a standard deviation of the updated simulated completion times of the workpiece order for each of the timed actions, and combining the mean and the standard deviation to create a composite score for the workpiece order;
identifying a plurality of top seeds as the seeds for which the workpiece order has a lower composite score than 90 percent of all of the workpiece orders subjected to the uncertainty analysis;
identifying, from among the top seeds, a best seed for which the workpiece order has the lowest composite score; and
outputting an uncertainty analysis list containing the best seed, the top seeds, and the associated composite scores.

14. The method (500) of Claim 13, further comprising:
evaluating, using a controller analysis tool (310), the effect of each one of the simulation controllers (206) on the completion time for processing the production configuration (190) by the manufacturing cell (400), each one of the simulation controllers (206) having a different set of rules for determining the order in which the timed actions are performed on the workpieces (452) in the production configuration (190), the step of evaluating including:
performing a batch analysis for simulating a plurality of workpiece orders of the production configuration (190), using one of the simulation controllers (206) previously unused in a simulation;
saving, for each workpiece order simulated via the batch analysis, the simulated completion time using the simulation controller (206), and the seed associated with each workpiece order;
determining, for the simulation controller (206), the seeds for which the workpiece order has a shorter simulated completion time than 90 percent of all of the workpiece orders simulated using the simulation controller (206);
repeating, for each simulation controller (206) until all simulation controllers (206) have results, the steps of performing the batch analysis, saving the simulated completion time and associated seed, and determining the seeds for the workpiece order that has the shorter simulated completion time;
performing, for each simulation controller (206), the uncertainty analysis on each workpiece order that has the shorter simulated completion time; and
outputting a list of the simulation controllers (206) and corresponding composite scores, to facilitate identifying the simulation controller (206) that results in the shortest simulated completion time for the production configuration (190).

15. The method (500) of any one of Claims 10-14, further comprising:
accessing, via the simulation manager (220), a statistical model (230) of the manufacturing cell (400) for estimating the quantity of work remaining to be performed on the workpiece order at any given point in time during processing of the workpiece order by the manufacturing cell (400);
receiving, from the statistical model (230), a best-case completion time (232) of the workpiece order, generated by a multiple linear regression that is fit to statistical model (230) parameters of the workpiece order, the statistical model (230) parameters at least including: quantity of workpieces (452) in the workpiece order, the mean of the timed actions in the production configuration (190), and the standard deviation of the timed actions in the production configuration (190);
continuously evaluating, using the simulation manager (220), the status of the simulation prior to simulating all of the workpieces (452) in the workpiece order, by sequentially performing the following after each update of the software model (250):
adding the duration of the most recently completed simulated timed action to a running total of the duration of the simulated timed actions performed up to the most recent update of the software model (250);
determining, at that point in the simulation, a statistically-modeled best-case interim time (234), calculated as a function of the statistically-modeled best-case completion time (232) and the sum of the duration of every timed action required to complete the workpiece order;
calculating the difference between the statistically-modeled best-case interim time (234) to the running total of the duration of the simulated timed actions; and
terminating the simulation of the workpiece order if the difference is greater than 50 percent of the best-case interim time (234).
